# EUROPEAN PATENT APPLICATION

(11) **EP 4 765 089 A1**
(43) Date of publication of application: **24.06.2026**
(21) Application number: 25218628.3
(22) Date of filing: 26.11.2025
(51) Int. Cl.: G09G 3/3233, H10D 86/40, H10K 59/131

(54) **DISPLAY DEVICE**

(30) Priority: 23.12.2024 KR 20240194239
(71) Applicant: LG Display Co., Ltd., Seoul, 07336 (KR)
(72) Inventor: CHO, Youngsung, 10845 Paju-si, Gyeonggi-do (KR); KIM, JuHan, 10845 Paju-si, Gyeonggi-do (KR)
(74) Representative: Viering, Jentschura & Partner mbB Patent- und Rechtsanwälte

(57) **Abstract**

A display device (100) according to embodiments of the present disclosure may include a substrate (111) including a display area (DA) and a non-display area (NDA) outside the display area (DA), the display area (DA) including an upper display area (DA_TOP), a lower display area (DA_BOT), and a middle display area (DA_MID) between the upper display area (DA_TOP) and the lower display area (DA_BOT), and the non-display area (NDA) including a pad area (PA) closer to the upper display area (DA_TOP) than the middle display area (DA_MID), and a plurality of data lines (DL) arranged in the display area (DA). An n-th data line (DL(n)) among the plurality of data lines (DL) may include an n-th upper data line (DL(n)_TOP) arranged in the upper display area (DA_TOP) and extending in a first direction, an n-th lower data line (DL(n)_BOT) arranged in the lower display area (DA_BOT) and extending in the first direction, and an n-th bypass link line (DL(n)_BLL) passing through the middle display area (DA_MID) and electrically connecting the n-th upper data line (DL(n)_TOP) and the n-th lower data line (DL(n)_BOT), wherein n is a natural number greater than or equal to 1.

## Description

### TECHNICAL FIELD

Embodiments of the present disclosure relate to a display device.

### BACKGROUND

A display panel of a display device may include a display area where an image is displayed and a non-display area where an image is not displayed. Here, the non-display area may also be referred to as a bezel. The smaller the size of the non-display area of the display panel, the easier it is to increase the size of the display area, implement the display device in various shapes, or apply to various applications. However, it is not easy to reduce the size of the non-display area due to the shape of the display device or the signal lines arranged on the display panel.

### SUMMARY

Embodiments of the present disclosure may provide a display device having a data line structure capable of implementing the bezel reduction.

Embodiments of the present disclosure may provide a display device having a power line structure capable of improving display driving performance and enabling low-power driving.

Embodiments of the present disclosure may provide a display device having a data link structure capable of reducing the bezel and a power line structure associated therewith, thereby enabling process optimization.

Embodiments of the present disclosure may provide a display device of a heterogeneous display type having a data link structure capable of reducing the bezel.

Embodiments of the present disclosure may provide a display device as a wearable device having a data link structure capable of reducing the bezel. Here, the wearable device may include a virtual reality (VR) device, an augmented reality (AR) device, a mixed reality (MR) device, or an extended reality (XR) device.

The objects of the embodiments of the present disclosure are not limited to the objects described in this disclosure, and other objects will be clearly understood by those skilled in the art from the description below. According to an aspect of the present disclosure, a display device according to claim 1 is provided. Further embodiments of the display device are described in the dependent claims.

A display device according to embodiments of the present disclosure may include a substrate including a display area and a non-display area outside the display area, the display area including an upper display area, a lower display area, and a middle display area between the upper display area and the lower display area, and the non-display area including a pad area closer to the upper display area than the middle display area, and a plurality of data lines arranged in the display area. An n-th data line among the plurality of data lines may include an n-th upper data line arranged in the upper display area and extending in a first direction, an n-th lower data line arranged in the lower display area and extending in the first direction, and an n-th bypass link line passing through the middle display area and electrically connecting the n-th upper data line and the n-th lower data line, wherein n is a natural number greater than or equal to 1.

A first boundary line may be defined between the upper display area and the middle display area, and a width of the middle display area may become narrower from the first boundary line toward a center of the middle display area. A second boundary line may be defined between the lower display area and the middle display area, and the width of the middle display area may become narrower from the second boundary line toward the center of the middle display area,.

The n-th bypass link line may include an n-th upper link line arranged in the display area, electrically connected to the n-th upper data line, and extending in a second direction different from the first direction, an n-th lower link line arranged in the display area, electrically connected to the n-th lower data line, and extending in the second direction, and an n-th middle link line arranged in the display area, electrically connecting the n-th upper link line and the n-th lower link line, and extending in the first direction.

A display device according to embodiments of the present disclosure may include a substrate including a display area, a first signal line disposed on the substrate, extending in a first direction in the display area, and disposed within a first metal layer, and a second signal line disposed on the substrate, extending in a second direction different from the first direction in the display area, and disposed within a second metal layer different from the first metal layer.

According to at least one of the embodiments of the present disclosure, it is possible to provide a display device having a data link structure capable of reducing a bezel by arranging data lines or link lines for connecting the data lines in a display area.

According to at least one of the embodiments of the present disclosure, it is possible to provide a display device having a power line structure in which power lines are arranged in a mesh form within a display area, thereby reducing the resistance of the power lines, improving the power supply characteristics through the power lines, improving display driving performance, and enabling the low-power driving.

According to at least one of the embodiments of the present disclosure, it is possible to provide a display device having a data link structure capable of reducing a bezel and a power line structure linked thereto, so that process optimization can be provided since the data link structure and the power line structure do not need to be formed separately.

According to at least one of the embodiments of the present disclosure, it is possible to provide a display device of a heterogeneous display type having a data link structure capable of reducing a bezel.

According to at least one of the embodiments of the present disclosure, it is possible to provide a display device as a wearable device having a data link structure capable of reducing a bezel.

The effects of the embodiments of the present disclosure are not limited to the effects described in this disclosure, and other effects will be clearly understood by those skilled in the art from the description of the claims.

### BRIEF DESCRIPTION OF THE DRAWINGS

The present disclosure will be more fully understood from the detailed description and accompanying drawings provided below, which are provided for illustration purposes only and are not intended to limit the present disclosure.
FIG. 1 illustrates a display device according to embodiments of the present disclosure.
FIG. 2 is an equivalent circuit for a sub-pixel of a display panel according to embodiments of the present disclosure.
FIG. 3 illustrates an arrangement structure of data lines of a display panel according to embodiments of the present disclosure.
FIG. 4 illustrates detailed areas included in a waist area of a display panel according to embodiments of the present disclosure.
FIG. 5 is a cross-sectional view of a display panel according to embodiments of the present disclosure.
FIGS. 6 to 8 are plan views of display panels according to embodiments of the present disclosure.
FIG. 9 is an enlarged plan view of a first area of a display panel according to embodiments of the present disclosure.
FIG. 10 is an enlarged plan view of a second area of a display panel according to embodiments of the present disclosure.
FIGS. 11 to 14 are enlarged plan views of first to fourth connection areas in the first area and second area of a display panel according to embodiments of the present disclosure.
FIGS. 15 to 18 are cross-sectional views of first to fourth main areas in the first to fourth connection areas.
FIGS. 19 to 22 are cross-sectional views of first to fourth main areas in the first to fourth connection areas.
FIG. 23 illustrates detailed areas included in a waist area of a display panel according to embodiments of the present disclosure.
FIG. 24 illustrates a structure of a non-display area in a first area of a display panel according to embodiments of the present disclosure.

### DETAILED DESCRIPTION

Implementations of the present disclosure may provide a display device having a data line structure capable of implementing the bezel reduction.

Implementations of the present disclosure may provide a display device having a power line structure capable of improving display driving performance and enabling low-power driving.

Implementations of the present disclosure may provide a display device having a data link structure capable of reducing the bezel and a power line structure associated therewith, thereby enabling process optimization.

Implementations of the present disclosure may provide a display device of a heterogeneous display type having a data link structure capable of reducing the bezel.

Implementations of the present disclosure may provide a display device as a wearable device having a data link structure capable of reducing the bezel. Here, the wearable device may include a virtual reality (VR) device, an augmented reality (AR) device, a mixed reality (MR) device, or an extended reality (XR) device.

The objects of the implementations of the present disclosure are not limited to the objects described in this disclosure, and other objects will be clearly understood by those skilled in the art from the description below.

In the following description of examples or embodiments of the present invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present invention, detailed descriptions of well-known functions and components incorporated herein will be omitted when it is determined that the description may make the subject matter in some embodiments of the present invention rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, various embodiments of the disclosure are described in detail with reference to the accompanying drawings.

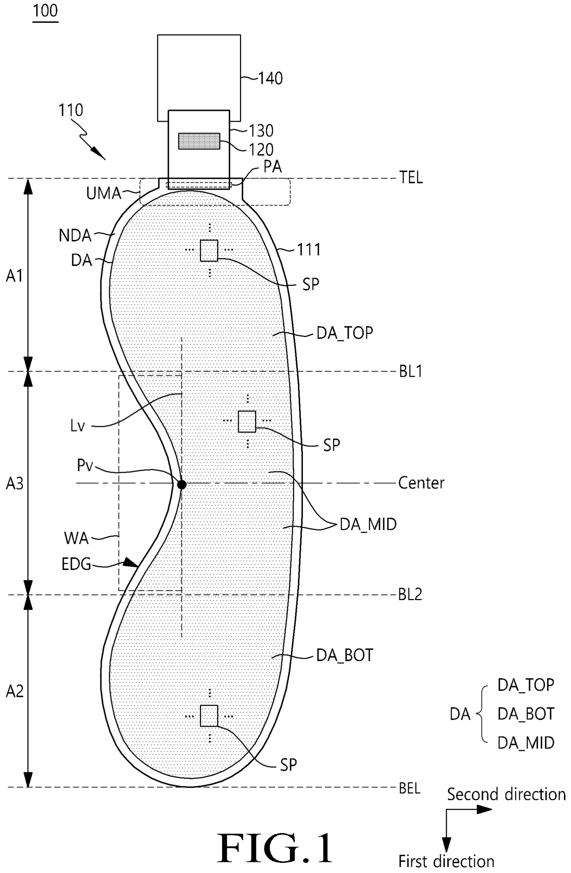

FIG. 1 illustrates a display device 100 according to embodiments of the present disclosure.

Referring to FIG. 1, a display device 100 according to embodiments of the present disclosure may include a display panel 110 and a driving circuit 120.

The display panel 110 may include a substrate 111 and a plurality of sub-pixels SP formed on the substrate 111.

The substrate 111 may include a display area DA capable of displaying an image and a non-display area NDA in which an image is not displayed. The display area DA and the non-display area NDA may be areas of the display panel 110. That is, the display panel 110 may include a display area DA and a non-display area NDA. Here, the non-display area NDA is also referred to as a bezel.

The substrate 111 may be divided into a plurality of areas. For example, the substrate 111 may include a first area A1, a second area A2, and a third area A3. The first area A1 may include a pad area PA. The second area A2 may be located farthest from the pad area PA among the first to third areas A1, A2 and A3. The third area A3 may be located between the first area A1 and the second area A2.

The display area DA may include an upper display area DA_TOP included in the first area A1, a lower display area DA_BOT included in the second area A2, and a middle display area DA_MID included in the third area A3. That is, the substrate 111 may include an first area A1 including an upper display area DA_TOP, a second area A2 including a lower display area DA_BOT, and a third area A3 including a middle display area DA_MID. The first area A1 may include a pad area PA.

The non-display area NDA may be an outer area of the display area DA, and may include a pad area PA that is closer to the upper display area DA_TOP than the middle display area DA_MID.

The substrate 111 may be a flexible substrate.

The substrate 111 may have an upper edge line TEL, a lower edge line BEL, a first boundary line BL1, and a second boundary line BL2.

The upper edge line TEL and the lower edge line BEL may be cut lines of the substrate 111. The upper edge line TEL may be an edge line of the substrate 111 near the pad area PA, and the lower edge line BEL may be an edge line of the substrate 111 opposite to the upper edge line TEL.

The substrate 111 may be bent near the upper edge line TEL. Accordingly, the pad area PA and the components connected thereto (e.g., driving circuit 120, flexible printed circuit board 130, and printed circuit board 140) may be positioned below the substrate 111.

The first boundary line BL1 may be a virtual line indicating a boundary between the upper display area DA_TOP and the middle display area DA_MID, and the second boundary line BL2 may be a virtual line indicating a boundary between the lower display area DA_BOT and the middle display area DA_MID.

A plurality of sub-pixels SP may be arranged in the display area DA. A plurality of sub-pixels SP may be arranged in each of the upper display area DA_TOP, the middle display area DA_MID, and the lower display area DA_BOT.

In the display device 100 according to the embodiments of the present disclosure, the third area A3 may include a waist area WA that is dug or curved inwardly. That is, one side of the third area A3 may be dug or curved inwardly.

Within the third area A3, the waist area WA may mean an area between a valley line Lv and an edge EDG of the substrate 111. The valley line Lv may be a virtual line that extends in a first direction while passing through a point (Pv, hereinafter referred to as "valley point") where the substrate 111 is dug inwardly most deeply.

For example, moving from the first boundary line BL1 (between the upper display area DA_TOP and the middle display area DA_MID) and approaching closer to the center of the middle display area DA_MID, the width of the middle display area DA_MID may become narrower. In addition, moving from the second boundary line BL2 (between the lower display area DA_BOT and the middle display area DA_MID) and approaching closer to the center of the middle display area DA_MID, the narrower the width of the middle display area DA_MID may become. Here, the width may mean a length in the second direction.

For example, the maximum width of the middle display area DA_MID may be smaller than each of the maximum width of the upper display area DA_TOP and the maximum width of the lower display area DA_BOT.

In the display device 100 according to the embodiments of the present disclosure, the driving circuit 120 may be electrically connected to the pad area PA in the non-display area NDA. For example, the driving circuit 120 may be mounted on a flexible printed circuit board 130, and one side of the flexible printed circuit board 130 may be connected to the pad area PA of the substrate 111. Here, the flexible printed circuit board 130 may also be referred to as a flexible printed circuit or a circuit film. A printed circuit board 140 may be connected to the other side of the flexible printed circuit board 130.

The driving circuit 120 may be implemented as an integrated circuit. The driving circuit 120 may include a data driving circuit that supplies a data signal corresponding to an image signal to sub-pixels SP in the display panel 110.

The display device 100 according to the embodiments of the present disclosure may further include a gate driving circuit that supplies a gate signal to sub-pixels SP in the display panel 110. As an example, the gate driving circuit may be located outside the display panel 110. As another example, the gate driving circuit may be located inside the display panel 110. The gate driving circuit present inside the display panel 110 may be referred to as a gate-in-panel (GIP) type, and may be disposed on the substrate 110. The gate driving circuit present inside the display panel 110 may also be called a gate-in-panel circuit. For example, the gate-in-panel circuit may be placed in a non-display area NDA.

If the gate driving circuit is present outside the display panel 110, the gate driving circuit may be included in the driving circuit 120 or may be present separately from the driving circuit 120.

The display device 100 according to the embodiments of the present disclosure may further include a controller for controlling the driving circuit 120 and the gate driving circuit. For example, the controller may be mounted on a printed circuit board 140.

The display device 100 according to the embodiments of the present disclosure may further include a case member covering the non-display area NDA of the display panel 110 and circuit configurations (e.g., a driving circuit 120, a flexible printed circuit board 130, and a printed circuit board 140). For example, the case member may include a wearable member that a user can wear on the face (e.g., a pair of glasses that can be hung on the ears, or a band that can be worn on the head).

Meanwhile, for example, the display device 100 according to the embodiments of the present disclosure may have a shape of glasses. For example, the display device 100 according to the embodiments of the present disclosure may be a heterogeneous display device or a wearable device in the shape of glasses. If the display device 100 according to the embodiments of the present disclosure is a wearable device in the shape of glasses, the user may wear the display device 100 like glasses. Accordingly, the waist area WA of the display device 100 may correspond to a position of the user's nose, and the upper edge line TEL of the first area A1 and the lower edge line BEL of the second area A2 may be adjacent to both ears of the user.

For example, the display device 100 according to the embodiments of the present disclosure may be at least one wearable device among a virtual reality (VR) device, an augmented reality (AR) device, a mixed reality (MR) device, and an extended reality (XR) device. For example, if the display device 100 is a wearable device that a user wears on his or her face, the surface on which an image is displayed among the two surfaces of the display device 100 may be the opposite surface of the surface that is closer to the user wearing the display device 100. Accordingly, an image displayed on a display device 100 worn by a user can be shown to other users around the wearer. For another example, if the display device 100 is a possible wearable device worn by a user on the face, the surface of the two surfaces of the display device 100 on which an image is displayed may be the surface closer to the user wearing the display device 100. For another example, if the display device 100 is a possible wearable device worn by a user on the face, the surface on which an image is displayed may be both the surface closer to the user wearing the display device 100 and the opposite surface.

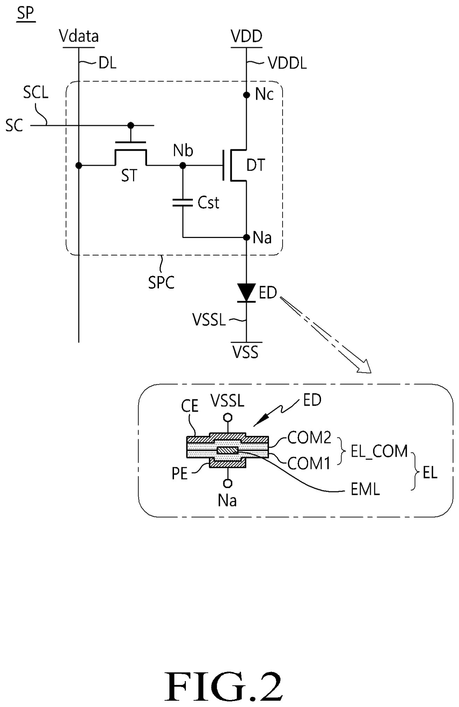

FIG. 2 is an equivalent circuit for a sub-pixel SP of a display panel 110 according to embodiments of the present disclosure.

Each sub-pixel SP of a display device 100 according to embodiments of the present disclosure may include a light emitting device ED and a sub-pixel circuit SPC for driving the light emitting device ED.

The light emitting device ED may be an organic light-emitting diode (OLED) based on an organic material, an inorganic light-emitting diode (LED) based on an inorganic material, or a quantum dot light emitting device. However, the present disclosure is not limited thereto. For convenience of explanation, it will be exemplified a case where the light emitting device ED is an organic light-emitting diode (OLED).

The sub-pixel circuit SPC may include a plurality of transistors and at least one capacitor for driving the light emitting device ED. The sub-pixel circuit SPC may drive the light emitting device ED by supplying a driving current to the light emitting device ED at a predetermined timing. The light emitting device ED may be driven by the driving current to emit light.

A plurality of transistors included in the sub-pixel circuit SPC may include a driving transistor DT for driving the light emitting device ED and a scan transistor ST that is turned on or off according to a scan signal SC.

The driving transistor DT may supply a driving current to the light emitting device ED. The scan transistor ST may be configured to control an electrical state of a corresponding node within the sub-pixel circuit SPC or to control a state or operation of the driving transistor DT. At least one capacitor may include a storage capacitor Cst for maintaining a constant voltage during a frame.

In order to drive the sub-pixel SP, a data signal Vdata as an image signal, and a scan signal SC as a type of gate signal may be applied to the sub-pixel SP. In addition, in order to drive the sub-pixel SP, a common driving signal including a driving voltage VDD and a base voltage VSS may be applied to the sub-pixel SP.

The light emitting device ED may include a pixel electrode PE, an intermediate layer EL, and a common electrode CE. The intermediate layer EL may be disposed between the pixel electrode PE and the common electrode CE. For example, the pixel electrode PE may be an electrode arranged in each sub-pixel SP, and the common electrode CE may be an electrode commonly arranged in a plurality of sub-pixels SP. For example, the pixel electrode PE may be an anode electrode, and the common electrode CE may be a cathode electrode. In another example, the pixel electrode PE may be a cathode electrode and the common electrode CE may be an anode electrode. In the following, for convenience of explanation, it will be exemplified a case where the pixel electrode PE is an anode electrode and the common electrode CE is a cathode electrode.

If the light emitting device ED is an organic light emitting device, the intermediate layer EL may include a emission layer EML, a first common intermediate layer COM1 between the pixel electrode PE and the emission layer EML, and a second common intermediate layer COM2 between the emission layer EML and the common electrode CE. The first common intermediate layer COM1 and the second common intermediate layer COM2 may be collectively referred to as a common intermediate layer EL_COM.

The emission layer EML may be disposed for each sub-pixel SP, or may be disposed commonly across a plurality of sub-pixels SP, and the common intermediate layer EL_COM may be disposed commonly across a plurality of sub-pixels SP, however, is not limited thereto.

The emission layer EML may be arranged in each emission area or may be arranged in common across a plurality of emission areas, and the common intermediate layer EL_COM may be arranged in common across a plurality of emission areas and non-emission areas, however, is not limited thereto.

For example, the first common intermediate layer COM1 may include a hole injection layer HIL, an electron blocking layer EBL, a hole transfer layer HTL, and the like, and the second common intermediate layer COM2 may include an electron transfer layer ETL, a hole blocking layer HBL, and an electron injection layer EIL, however, is not limited thereto. The hole injection layer HIL may inject holes from the pixel electrode PE to the hole transport layer HTL, and the hole transport layer HTL may transport holes to the emission layer EML, and the electron injection layer EIL may inject electrons from the common electrode CE to the electron transport layer ETL, and the electron transport layer ETL may transport electrons to the emission layer EML.

For example, the common electrode CE may be electrically connected to a base voltage line VSSL. A base voltage VSS, which is a type of common voltage, may be applied to the common electrode CE through the base voltage line VSSL. The pixel electrode PE may be electrically connected directly or indirectly (e.g., via another transistor) to a first node Na of the driving transistor DT of each sub-pixel SP. In the present disclosure, the base voltage VSS may also be referred to as a first common voltage, a low-potential power supply voltage, or a low-potential voltage, and the base voltage line VSSL may also be referred to as a first common voltage line, a low-potential power supply voltage line, or a low-potential voltage line.

Each light emitting device ED may be composed of an overlapping portion of a pixel electrode PE, an emission layer EML in an intermediate layer EL, and a common electrode CE. A predetermined light-emission area may be formed by each light emitting device ED. For example, the emission area of each light emitting device ED may include an overlapping area of a pixel electrode PE, an emission layer EML in an intermediate layer EL, and a common electrode CE.

The driving transistor DT may be a driving transistor for supplying a driving current to the light emitting device ED. The driving transistor DT may be connected between a driving voltage line VDDL and the light emitting device ED.

The driving transistor DT may include a first node Na, a second node Nb, and a third node Nc. The first node Na may be electrically connected to the light emitting device ED, the second node Nb may receive a data signal Vdata, and the third node Nc may receive a driving voltage VDD, which is another type of common voltage, from a driving voltage line VDDL. The driving transistor DT may be connected to the first node Na and the third node Nc. In the present disclosure, the driving voltage VDD may also be described as a second common voltage, a high-potential power supply voltage, or a high-potential voltage, and the driving voltage line VDDL may also be described as a second common voltage line, a high-potential power supply voltage line, or a high-potential voltage line.

In the driving transistor DT, the second node Nb may be a gate node, the first node Na may be a source node or a drain node, and the third node Nc may be a drain node or a source node. Hereinafter, for convenience of explanation, in the driving transistor DT, the second node Nb may be a gate node, the first node Na may be a source node, and the third node Nc may be a drain node, however, is not limited thereto.

The scan transistor ST included in the sub-pixel circuit SPC illustrated in FIG. 2 may be a switching transistor for transmitting a data signal Vdata, which is an image signal, to the second node Nb, which is a gate node of the driving transistor DT.

The scan transistor ST may be turned on and off by a scan signal SC, which is a type of gate signal applied through a scan line SCL, which is a type of gate line, so as to control the electrical connection between the second node Nb of the driving transistor DT and a data line DL. The drain electrode or the source electrode of the scan transistor ST may be electrically connected to the data line DL, the source electrode or the drain electrode of the scan transistor ST may be electrically connected to the second node Nb of the driving transistor DT, and the gate electrode of the scan transistor ST may be electrically connected to the scan line SCL.

The storage capacitor Cst may be electrically connected between the first node Na and the second node Nb of the driving transistor DT. The storage capacitor Cst may include at least one capacitor electrode electrically connected to the first node Na of the driving transistor DT or corresponding to the first node Na of the driving transistor DT, and at least one capacitor electrode electrically connected to the second node Nb of the driving transistor DT or corresponding to the second node Nb of the driving transistor DT.

The storage capacitor Cst may be an external capacitor intentionally designed outside the driving transistor DT, rather than a parasitic capacitor (e.g., Cgs, Cgd) that may be an internal capacitor between the first node Na and the second node Nb of the driving transistor DT, but, is not limited thereto.

Each of the driving transistor DT and the scan transistor ST may be an n-type transistor or a p-type transistor. However, it is not limited thereto. For example, one of the driving transistor DT and the scan transistor ST may be one of an n-type transistor and a p-type transistor.

The display panel 110 may have a top emission structure or a bottom emission structure. If the display panel 110 has a top emission structure, at least a part of the sub-pixel circuit SPC may overlap with at least a part of the light emitting device ED in the vertical direction. Accordingly, the area of the emission area may be increased and the aperture ratio may be increased. If the display panel 110 has a bottom emission structure, the sub-pixel circuit SPC may not overlap with the light emitting device ED in the vertical direction.

The sub-pixel circuit SPC may have a 2T (Transistor) 1C (Capacitor) structure including two transistors (e.g., DT and ST) and one capacitor Cst as illustrated in FIG. 2, and may further include one or more transistors or one or more capacitors, depending on the case.

Depending on the structure of the sub-pixel circuit SPC, the type and number of gate signal supplied to the sub-pixel SP may vary. In addition, depending on the structure of the sub-pixel circuit SPC, the type and number of common driving signals supplied to the sub-pixel SP may vary.

Since the circuit elements (e.g., light emitting devices ED implemented as organic light-emitting diodes (OLED) including organic materials) in each sub-pixel SP are vulnerable to external moisture or oxygen, the display panel 110 may further include an encapsulation layer disposed on the light emitting devices ED. The encapsulation layer may prevent external moisture or oxygen from penetrating into the circuit elements (e.g., light emitting devices ED). The encapsulation layer may be configured in various forms so that the light emitting devices ED do not come into contact with moisture or oxygen. For example, the encapsulation layer may be configured with two or more layers in which organic films and inorganic films are alternately laminated. However, the present disclosure is not limited thereto.

The display device 100 may further include a touch sensor layer in which a touch sensor is formed, and a touch sensing circuit that senses the touch sensor formed in the touch sensor layer to determine the presence or absence of a touch or the touch coordinates in order to provide a touch sensing function.

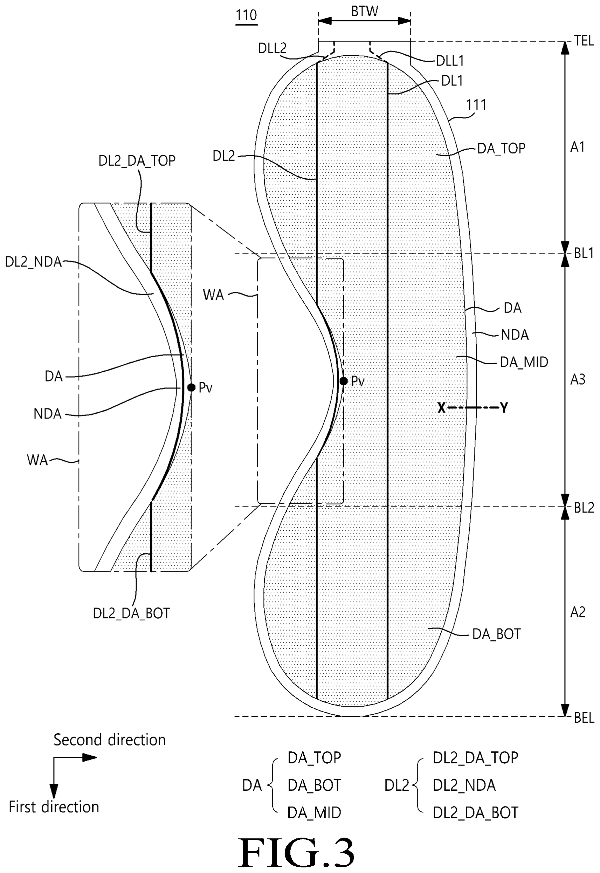

FIG. 3 illustrates the arrangement structure of data lines of the display panel 110 according to embodiments of the present disclosure. In the following description, FIG. 1 and FIG. 2 are also referred to.

The display panel 110 may include a first area A1 and a second area A2, and a third area A3 between the first area A1 and the second area A2. The first area A1 may be an area where circuit components (e.g., a driving circuit 120, a flexible printed circuit board 130, and a printed circuit board 140) are connected. The width BTW of a portion corresponding to the upper edge line TEL in the first area A1 may have a smaller value than other portions.

The display panel 110 may include a plurality of data lines DL for transmitting data signals Vdata to a plurality of sub-pixels SP. The plurality of data lines DL may be arranged in the display area DA.

Depending on the shape (e.g., a glasses shape) of the substrate 111 of the display panel 110, the plurality of data lines DL may include a plurality of first data lines DL1 that do not pass through the waist area WA and a plurality of second data lines DL2 that pass through the waist area WA.

Each of the plurality of first data lines DL1 may be connected to a first data link line DLL1 that extends from the pad area PA through the upper edge line TEL to the upper display area DA_TOP, and may be arranged to extend in a first direction within the upper display area DA_TOP.

Each of the plurality of first data lines DL1 may extend in the first direction in all of the upper display area DA_TOP, the middle display area DA_MID, and the lower display area DA_BOT,and may be arranged without bending.

Each of the plurality of second data lines DL2 may be connected to a second data link line DLL2 that extends from the pad area PA through the upper edge line TEL to the upper display area DA_TOP, and may be arranged while extending in the first direction within the upper display area DA_ TOP.

However, each of the plurality of second data lines DL2 may be arranged while bending inwardly so as to be arranged on the substrate 111 that is dug or curved inwardly when passing through the waist area WA within the middle display area DA_MID.

In scenarios where each of the plurality of second data lines DL2 is bent while passing through the waist area WA, the each of the plurality of second data lines DL2 may pass through the non-display area NDA (e.g., a bezel) of the waist area WA, as shown in FIG. 3. In some implementations, each of the plurality of second data lines DL2 may include an upper data line DL2_DA_TOP arranged in the upper display area DA_TOP, a lower data line DL2_DA_BOT arranged in the lower display area DA_BOT, and a bypass data line DL2_NDA that connects the upper data line DL1_DA_TOP and the lower data line DL2_DA_BOT and is arranged in the non-display area NDA in the waist area WA.

As described above, each of the plurality of second data lines DL2 may be arranged while bending in the waist area WA, and the bypass data line DL2_NDA of each of the plurality of second data lines DL2 is arranged in the non-display area NDA. As a result, the size of the non-display area NDA included in the waist area WA may increase, resulting in a larege bezel.

Accordingly, in the case that the display device 100 according to the embodiments of the present disclosure is a wearable device in the shape of glasses, if the size of the non-display area NDA included in the waist area WA increases, the design quality of the display device 100 may decrease, or the display device 100 may become uncomfortable to wear.

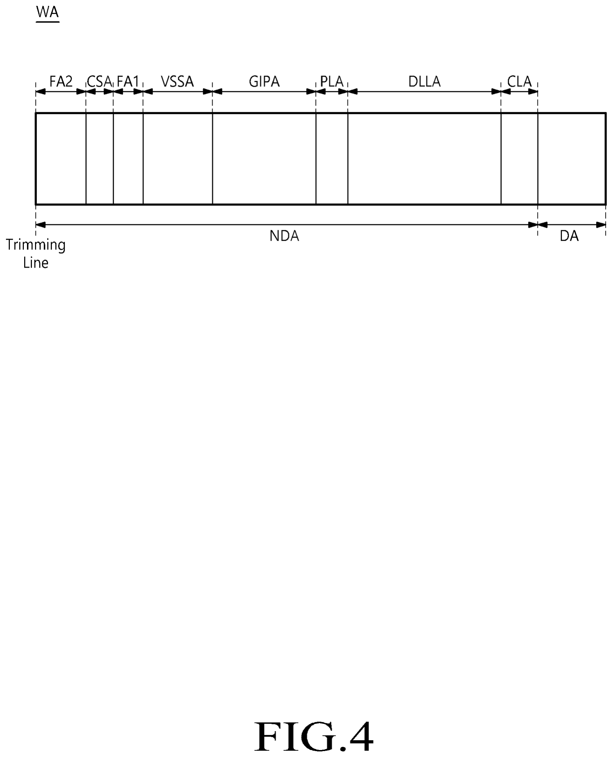

FIG. 4 illustrates detailed areas included in the waist area WA of the display panel 110 according to the embodiments of the present disclosure.

The non-display area NDA included in the waist area WA may include a data link area DLLA in which a plurality of bypass data lines DL2_NDA of a plurality of second data lines DL2 are arranged, a driving power line area PLA in which driving power lines are arranged, a gate-in-panel circuit area GIPA in which a gate-in-panel circuit, which is a gate driving circuit of a gate-in-panel type, is arranged, a base voltage line area VSSA in which a base voltage line VSSL is arranged, and a crack stopper area CSA in which a crack stopper structure is disposed.

In the driving power line area PLA, gate driving-related link lines connected to the gate-in-panel circuit and driving power lines for transmitting various driving powers (e.g., initialization voltage, reference voltage, etc.) to the sub-pixels SP may be arranged.

The non-display area NDA included in the waist area WA may further include a connection area CLA in which the driving power lines arranged in the driving power line area PLA are extended and gate lines for transmitting gate signals output from the gate-in-panel circuit to the sub-pixels SP are arranged.

The non-display area NDA included in the waist area WA may further include a first free space FA1 between the base voltage line area VSSA and the crack stopper area CSA, and a second free space FA2 between the crack stopper area CSA and a trimming line. Here, the trimming line may correspond to a cutting line of the substrate 111.

As described above, each of the plurality of second data lines DL2 may be arranged while bending in the waist area WA, and since the bypass data line DL2_NDA of each of the plurality of second data lines DL2 may be arranged in the non-display area NDA, this may result in the non-display area NDA included in the waist area WA having a large-sized data link area DLLA.

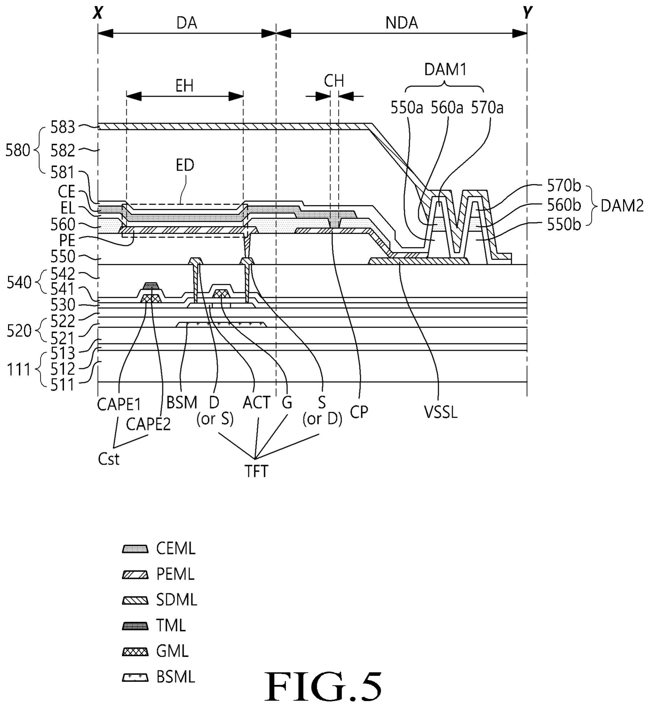

FIG. 5 is a cross-sectional view of a display panel 110 according to embodiments of the present disclosure. FIG. 5 is a cross-sectional view taken along the X-Y line of FIG. 3.

The display panel 110 according to embodiments of the present disclosure may include a display area DA and a non-display area NDA.

The display panel 110 according to the embodiments of the present disclosure may include a substrate 111, a buffer layer 520 disposed on the substrate 111, a gate insulating layer 530 disposed on the buffer layer 520, an interlayer insulating layer 540 disposed on the gate insulating layer 530, a planarization layer 550 disposed on the interlayer insulating layer 540, a light emitting device ED disposed on the planarization layer 550 and positioned in the display area DA, and an encapsulation layer 580 disposed on the light emitting device ED.

The substrate 111 may be a single layer or a multilayer. If the substrate 111 is a multilayer, the substrate 111 may include a first substrate 511, an intermediate substrate layer 512, and a second substrate 513. The intermediate substrate layer 512 may be positioned between the first substrate 511 and the second substrate 513. For example, each of the first substrate 511 and the second substrate 513 may be a polyimide (PI) layer, however, is not limited thereto. The intermediate substrate layer 512 may be an inorganic insulating layer, however, is not limited thereto. When a charge is charged on the first substrate 511 which is a polyimide layer, the intermediate substrate layer 512 may block the charge from affecting the transistors arranged on the second substrate 513 through the second substrate 513 which is a polyimide layer.

In addition, the intermediate substrate layer 512 may block moisture components from penetrating upward through the second substrate 513. For example, the intermediate substrate layer 512 may be formed of a single layer of silicon nitride (SiNx) or silicon oxide (SiOx) or a multilayer thereof, and may also be formed of a double layer of silicon dioxide (SiO2) and silicon nitride (SiNx). However, the embodiments of the present disclosure are not limited thereto.

The buffer layer 520 may be a single layer or a multilayer, however, is not limited thereto. If the buffer layer 520 is a multilayer, the buffer layer 520 may include a first buffer layer 521 and a second buffer layer 522.

The display panel 110 may further include a transistor TFT and a storage capacitor Cst arranged on the buffer layer 520. The transistor TFT may include an active layer ACT, a gate electrode G, a source electrode S, and a drain electrode D. The storage capacitor Cst may include a first capacitor electrode CAPE1 and a second capacitor electrode CAPE2.

The active layer ACT of the transistor TFT may be disposed on the buffer layer 520, and a gate insulating layer 530 may be disposed on the active layer ACT of the transistor TFT.

The gate electrode G of the transistor TFT may be disposed on the gate insulating layer 530, and may overlap with at least a portion of the active layer ACT.

The interlayer insulating layer 540 may include a first interlayer insulating layer 541 and a second interlayer insulating layer 542. The first interlayer insulating layer 541 may be disposed on the gate electrode G of the transistor TFT. The second interlayer insulating layer 542 may be disposed on the first interlayer insulating layer 541.

The source electrode S and the drain electrode D of the transistor TFT may be disposed on the second interlayer insulating layer 542. The source electrode S of the transistor TFT may be connected to a portion of the active layer ACT through a hole of the second interlayer insulating layer 542 and the first interlayer insulating layer 541 and the gate insulating layer 530, and the drain electrode D of the transistor TFT may be connected to another portion of the active layer ACT of the transistor TFT through another hole of the second interlayer insulating layer 542 and the first interlayer insulating layer 541 and the gate insulating layer 530.

The first capacitor electrode CAPE1 may be disposed on the gate insulating layer 530, and the second capacitor electrode CAPE2 may be disposed on the first interlayer insulating layer 541 and may overlap with the first capacitor electrode CAPE1.

The first capacitor electrode CAPE1 may be disposed in the same metal layer as the gate electrode G of the transistor TFT, and the second capacitor electrode CAPE2 may be disposed between the gate electrode G and the source/drain electrodes of the transistor TFT.

The planarization layer 550 may be disposed on the second interlayer insulating layer 542.

The light emitting device ED may be disposed on the planarization layer 550, and may include a pixel electrode PE, an intermediate layer EL, and a common electrode CE.

The pixel electrode PE may be disposed on the planarization layer 550, and may be electrically connected to a source electrode S or a drain electrode D of a transistor TFT through a hole in the planarization layer 550.

A bank 560 may be disposed on the planarization layer 550 and the pixel electrode PE, and may have an emission hole EH through which a portion of the pixel electrode PE is exposed. The emission hole EH of the bank 560 may correspond to an emission area of the light emitting device ED.

The intermediate layer EL may be disposed on the bank 560, and may be arranged in contact with an upper surface of the pixel electrode PE in the emission hole EH of the bank 560.

The common electrode CE may be disposed on the intermediate layer EL.

The encapsulation layer 580 may be disposed on the common electrode CE. The encapsulation layer 580 may include a first encapsulation layer 581, a second encapsulation layer 582, and a third encapsulation layer 583. The first encapsulating layer 581 and the third encapsulating layer 583 may be inorganic layers, and the second encapsulating layer 582 may be an organic layer.

The display panel 110 may further include a first dam DAM1 arranged outside the second encapsulation layer 582. For example, the first dam DAM1 may include a plurality of dam configuration layers 550a, 560a and 570a. For example, the plurality of dam configuration layers may include a first dam configuration layer 550a, a second dam configuration layer 560a, and a third dam configuration layer 570a. The first dam configuration layer 550a may include the same organic insulating material as the planarization layer 550, the second dam configuration layer 560a may include the same organic insulating material as the bank 560, and the third dam configuration layer 570a may include the same organic insulating material as a spacer (not shown in FIG.5) that can be disposed on the bank 560.

The display panel 110 may further include a second dam DAM2 located outside the first dam DAM1. For example, the second dam DAM2 may include a plurality of dam configuration layers 550b, 560b and 570b, similar to the first dam DAM1.

The first encapsulation layer 581 may be disposed on the common electrode CE, but may extend beyond the first dam DAM1 and the second dam DAM2 to the outside of the second dam DAM2.

The third encapsulation layer 583 may be disposed on the second encapsulation layer 582, but may extend further outside than the second encapsulation layer 582, so as to be extended to the outer periphery of the second dam DAM2 by passing over the upper part of the second dam DAM2, together with the first encapsulation layer 581.

The display panel 110 may further include a base voltage line VSSL to which a base voltage VSS is applied, and a connection pattern CP that electrically connects the common electrode CE and the base voltage line VSSL.

The base voltage line VSSL may be arranged between the second interlayer insulating layer 542 and the planarization layer 550. The base voltage line VSSL may be arranged under the planarization layer 550 and may extend to a lower portion of the first dam DAM1.

The connection pattern CP may be disposed between the bank 560 and the planarization layer 550. For example, the connection pattern CP may be located in the non-display area NDA. The connection pattern CP may extend from the upper surface of the planarization layer 550 along the side surface of the planarization layer 550, and may be electrically connected to the base voltage line VSSL.

The bank 560 may further have a connection hole CH. For example, the connection hole CH of the bank 560 may be located in the non-display area NDA.

The common electrode CE may extend from the display area DA to a portion of the non-display area NDA. In the non-display area NDA, the common electrode CE may be electrically connected to an upper surface of the connection pattern CP through the connection hole CH of the bank 560.

The display panel 110 may further include a lower shield metal BSM that overlaps with the active layer ACT of the transistor TFT. The lower shield metal BSM may be disposed between the substrate 111 and the buffer layer 520, or may be disposed between the first buffer layer 521 and the second buffer layer 522.

The display panel 110 may include various metal layers. For example, the display panel 110 may include a lower shield metal layer BSML on which a lower shield metal BSM is disposed, a gate metal layer GML on which a gate electrode G of a transistor TFT and a first capacitor electrode CAPE1 of a storage capacitor Cst are disposed, a capacitor electrode metal layer TML on which a second capacitor electrode CAPE2 of a storage capacitor Cst is disposed, a source-drain metal layer SDML on which a source electrode S and a drain electrode D of a transistor TFT are disposed, a pixel electrode metal layer PEML on which a pixel electrode PE is disposed, and a common electrode metal layer CEML on which a common electrode CE is disposed.

Meanwhile, as described above with reference to FIG. 3 and FIG. 4, due to the shape of the display panel 110, the size of the non-display area NDA included in the waist area WA may increase as data lines (e.g., bypass data lines) to which data signals are applied are arranged in the non-display area NDA. As a result, if the display device 100 according to the embodiments of the present disclosure is a wearable device in the shape of glasses, the design quality of the display device 100 may deteriorate or the display device 100 may become uncomfortable to wear.

Accordingly, the embodiments of the present disclosure may provide a "bezel-reducing data link structure" that can reduce the size of the non-display area NDA included in the waist area WA of the display panel 110. The embodiments of the present disclosure may provide a power line structure capable of improving display driving performance. The embodiments of the present disclosure may provide a power line structure linked to the bezel-reducing data link structure.

Hereinafter, it will be described a data link structure capable of implementing the bezel reduction according to embodiments of the present disclosure. It will be described a data link structure capable of implementing the bezel reduction and a power line structure linked to the data link structure for reducing the bezel according to embodiments of the present disclosure. However, in the following description, reference will be made to FIGS. 1 to 5 together.

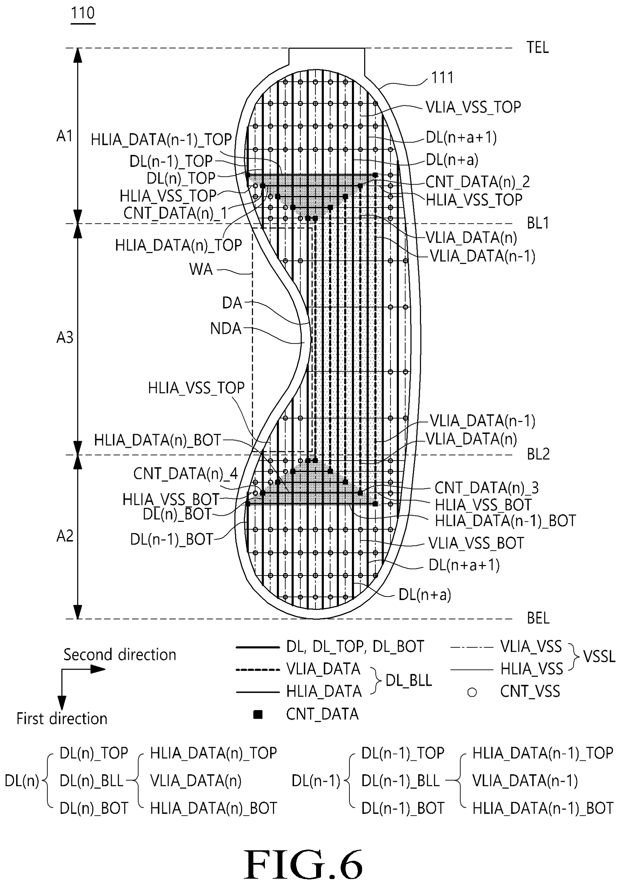

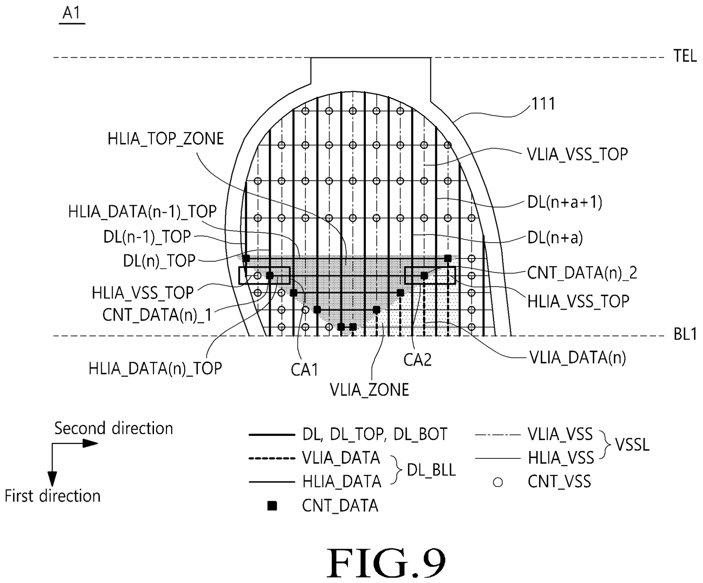

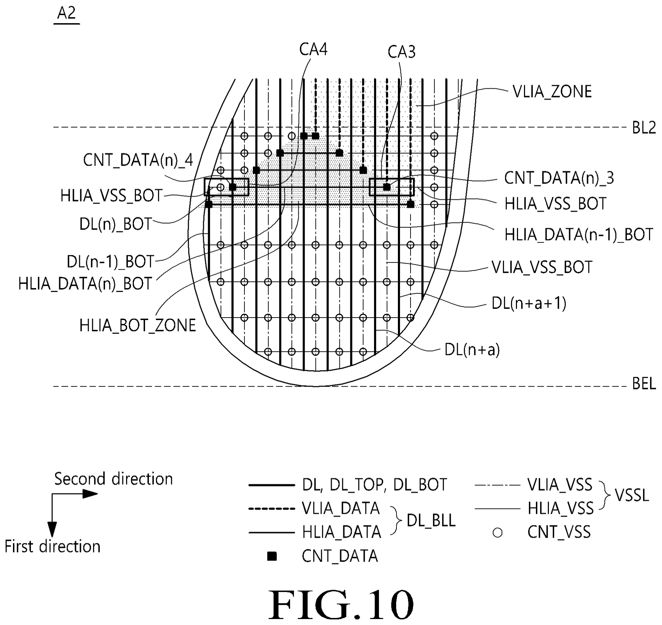

FIGS. 6 to 8 are plan views of display panels 110 according to embodiments of the present disclosure, FIG. 9 is an enlarged plan view of a first area A1 of a display panel 110 according to embodiments of the present disclosure, and FIG. 10 is an enlarged plan view of a second area A2 of a display panel 110 according to embodiments of the present disclosure. Compared to FIG. 3 in which the data line DL curves around the waist area WA by being impemented in the non-display area NDA, the examples of FIGS. 6 to 8 can achieve reduced bezel size by implementing a bypass link line DL_BLL in the display area DA (rather than in the non-display area NDA) and bypasses the waist area WA.

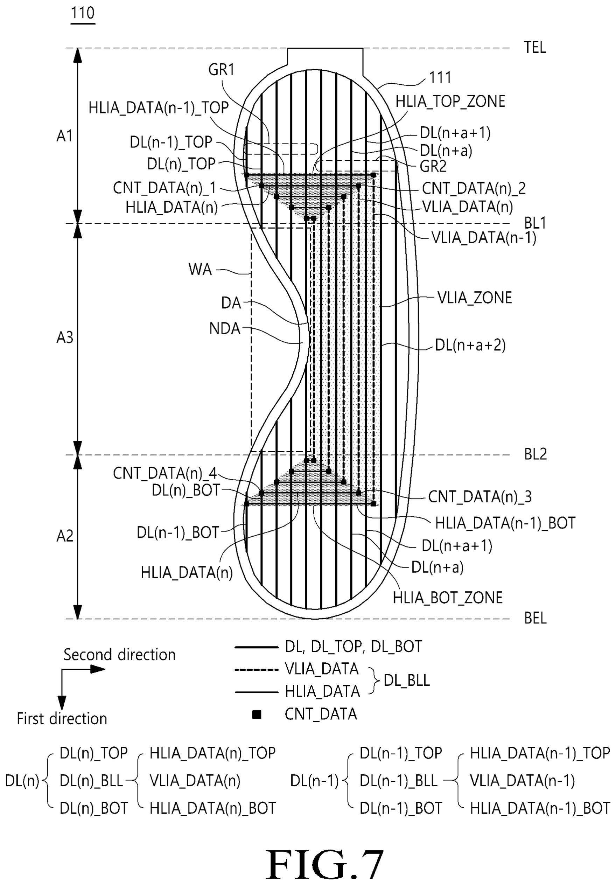

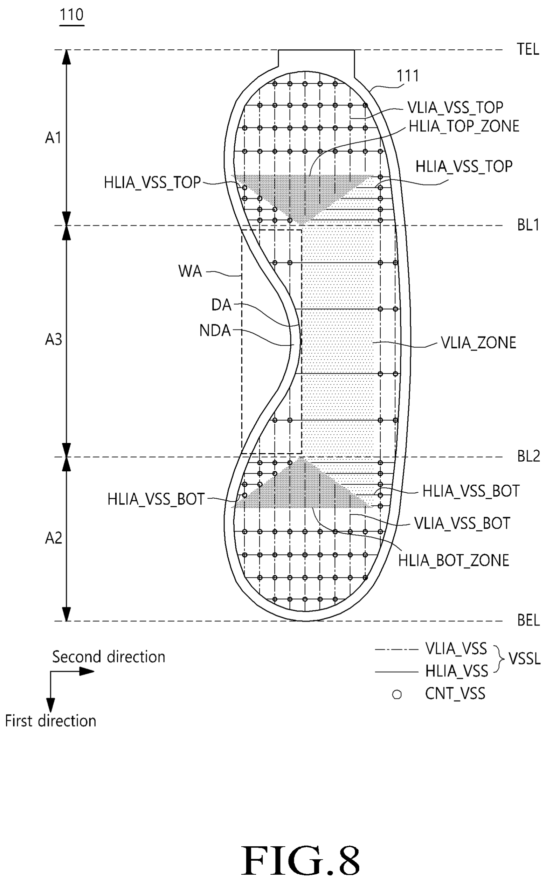

FIG. 6 is a plan view illustrating a data link structure capable of implementing the bezel reduction and a power line structure according to embodiments of the present disclosure, FIG. 7 is a plan view illustrating only a data link structure capable of implementing the bezel reduction while omitting the power line structure in FIG. 6, and FIG. 8 is a plan view illustrating only a power line structure while omitting the data link structure capable of implementing the bezel reduction in FIG. 6.

FIG. 9 is an enlarged plan view of a first area A1 of FIG. 6, and FIG. 10 is an enlarged plan view of a second area A2 of FIG. 6.

Referring to FIGS. 6 to 8, the substrate 111 of the display panel 110 may include a first area A1, a second area A2, and a third area A3. The third area A3 may be located between the first area A1 and the second area A2. The first area A1 may be an area between an upper edge line TEL and a first boundary line BL1, the third area A3 may be an area between the first boundary line BL1 and a second boundary line BL2, and the second area A2 may be an area between the second boundary line BL2 and a lower edge line BEL. The first area A1 and the second area A2 may be defined by a data link structure.

The substrate 111 may include a display area DA and a non-display area NDA outside the display area DA.

The display area DA may include an upper display area DA_TOP, a middle display area DA_MID, and a lower display area DA_BOT. The middle display area DA_MID may be located between the upper display area DA_TOP and the lower display area DA_BOT.

The upper display area DA_TOP may be included in the first area A1, the lower display area DA_BOT may be included in the second area A2, and the middle display area DA_MID may be included in the third area A3.

The display area DA may include a plurality of data lines DL.

The substrate 111 may include a waist area WA included in the third area A3. The waist area WA may be an area where the substrate 111 is dug or curved inwardly within the third area A3.

According to the data link structure capable of reducing the bezel according to the embodiments of the present disclosure, the display area DA of the substrate 111 may further include a data link structure connected to all or part of the plurality of data lines DL. Accordingly, there is no need for a bypass data line DL2_NDA to be arranged in the non-display area NDA in the waist area WA of the substrate 111. Accordingly, the size of the non-display area NDA in the waist area WA of the substrate 111 can be reduced.

The plurality of data lines DL may be classified into "a first data line group GR1" having a bypass link line DL_BLL that bypasses the waist area WA in the display area DA, and "a second data line group GR2" that extends in a first direction in a straight line shape and does not have a bypass link line DL_BLL because there is no need to bypass the waist area WA in the display area DA.

Each data line DL belonging to the first data line group GR1 among the plurality of data lines DL may include an upper data line DL_TOP, a lower data line DL_BOT, and a bypass link line DL_BLL.

The bypass link line DL_BLL may be arranged to bypass a waist area WA that is dug inwardly within the middle display area DA_MID.

The upper data line DL_TOP of each data line DL belonging to the first data line group GR1 may be arranged in the upper display area DA_TOP, and may extend in the first direction.

The lower data line DL_BOT of each data line DL belonging to the first data line group GR1 may be arranged in the lower display area DA_BOT, and may extend in the first direction.

The bypass link line DL_BLL of each data line DL belonging to the first data line group GR1 may pass through the middle display area DA_MID, and may electrically connect the upper data line DL_TOP and the lower data line DL_BOT.

Here, the first direction and the second direction may be different directions and may be relative directions. For example, the first direction may be a vertical direction and the second direction may be a horizontal direction. For another example, the first direction may be a horizontal direction and the second direction may be a vertical direction. However, hereinafter, for the convenience of explanation, it will be exemplified a case in which the first direction is a vertical direction and the second direction is a horizontal direction, however, is not limited thereto.

The bypass link line DL_BLL of each data line DL belonging to the first data line group GR1 may include an upper link line, a lower link line, and a middle link line.

The upper link line may be arranged in the display area DA, may be electrically connected to the upper data line DL_TOP, and may extend in the second direction different from the first direction.

The lower link line may be arranged in the display area DA, may be electrically connected to the lower data line DL_BOT, and may extend in the second direction.

The middle link line may be arranged in the display area DA, may electrically connect the upper link line and the lower link line, and may extend in the first direction. One end of the middle link line VLIA_DATA(n) may be electrically connected to the upper link line. The other end of the middle link line may be electrically connected to the lower link line.

The upper link line may be arranged in the upper display area DA_TOP. The lower link line may be arranged in the lower display area DA_BOT. The middle link line may pass through the middle display area DA_MID in the first direction.

Hereinafter, a data link structure capable of implementing the bezel reduction according to embodiments of the present disclosure will be described again using an n-th data line DL(n) and an (n-1)-th data line DL(n-1) among a plurality of data lines DL. The n-th data line DL(n) may be a data line (e.g., signal line) for transmitting an n-th data signal, and the (n-1)-th data line DL(n-1) may be a data line (e.g., signal line) for transmitting an (n-1)-th data signal.

Referring to FIGS. 6, 7, 11, 12, 13, and 14, the n-th data line DL(n) may include an n-th upper data line DL(n)_TOP, an n-th lower data line DL(n)_BOT, and an n-th bypass link line DL(n)_BLL.

The n-th upper data line DL(n)_TOP may be arranged in the upper display area DA_TOP, and may extend in the first direction.

The n-th lower data line DL(n)_BOT may be arranged in the lower display area DA_BOT, and may extend in the first direction.

The n-th bypass link line DL(n)_BLL may be arranged to bypass a waist area WA dug inwardly within the middle display area DA_MID.

The n-th bypass link line DL(n)_BLL may be arranged according to the shape of the waist area WA. The n-th bypass link line DL(n)_BLL may be arranged in a bent shape. The n-th bypass link line DL(n)_BLL may pass through the middle display area DA_MID and electrically connect the n-th upper data line DL(n)_TOP and the n-th lower data line DL(n)_BOT.

Referring to FIGS. 6 and 7, the n-th bypass link line DL(n)_BLL may include an n-th upper link line HLIA_DATA(n)_TOP, an n-th lower link line HLIA_DATA(n)_BOT, and an n-th middle link line VLIA_DATA(n).

The n-th upper link line HLIA_DATA(n)_TOP may be arranged in the display area DA, may be electrically connected to the n-th upper data line DL(n)_TOP at a first connection point CNT_DATA(n)_1, and may extend in the second direction different from the first direction.

The n-th lower link line HLIA_DATA(n)_BOT may be arranged in the display area DA, may be electrically connected to the n-th lower data line DL(n)_BOT at a fourth connection point CNT_DATA(n)_4, and may extend in the second direction.

The n-th middle link line VLIA_DATA(n) may be arranged in the display area DA, may electrically connect the n-th upper link line HLIA_DATA(n)_TOP and the n-th lower link line HLIA_DATA(n)_BOT, and may extend in the first direction.

One end of the n-th middle link line VLIA_DATA(n) may be electrically connected to the n-th upper link line HLIA_DATA(n)_TOP at a second connection point CNT_DATA(n)_2. The other end of the n-th middle link line VLIA_DATA(n) may be electrically connected to the n-th lower link line HLIA_DATA(n)_BOT at a third connection point CNT_DATA(n)_3.

The n-th upper link line HLIA_DATA(n)_TOP may be arranged in the upper display area DA_TOP. The n-th lower link line HLIA_DATA(n)_BOT may be arranged in the lower display area DA_BOT. The n-th middle link line VLIA_DATA(n) may pass through the middle display area DA_MID in the first direction.

The (n-1)-th data line DL(n-1) may include an (n-1)-th upper data line DL(n-1) _TOP, an (n-1)-th lower data line DL(n-1) BOT, and an (n-1)-th bypass link line DL(n-1)_BLL.

The (n-1)-th upper data line DL(n-1)_TOP may be arranged in the upper display area DA_TOP, and may extend in the first direction.

The (n-1)-th lower data line DL(n-1)_ BOT may be arranged in the lower display area DA_BOT, and may extend in the first direction.

The (n-1)-th bypass link line DL(n-1)_BLL may pass through the middle display area DA_MID, and electrically connect the (n-1)-th upper data line DL(n-1)_TOP and the (n-1)-th lower data line DL(n-1)_BOT.

The (n-1)-th bypass link line DL(n-1)_BLL may include an (n-1)-th upper link line HLIA_DATA(n-1)_TOP, an (n-1)-th middle link line VLIA_DATA(n-1), and an (n-1)-th lower link line HLIA_DATA(n-1)_BOT.

The (n-1)-th upper link line HLIA_DATA(n-1)_TOP may be arranged in the display area DA, may be electrically connected to the (n-1)-th upper data line DL(n-1) _TOP, and may extend in a second direction different from the first direction.

The (n-1)-th lower link line HLIA_DATA(n-1)_BOT may be arranged in the display area DA, may be electrically connected to the (n-1)-th lower data line DL(n-1)_BOT, and may extend in a second direction.

The (n-1)-th middle link line VLIA_DATA(n-1) may be arranged in the display area DA, may electrically connect the (n-1)-th upper link line HLIA_DATA(n-1)_TOP and the (n-1)-th lower link line HLIA_DATA(n-1)_BOT, and may extend in the first direction.

One end of the (n-1)-th middle link line VLIA_DATA(n-1) may be electrically connected to the (n-1)-th upper link line HLIA_DATA(n-1)_TOP. The other end of the (n-1)-th middle link line VLIA_DATA(n-1) may be electrically connected to the (n-1)-th lower link line HLIA_DATA(n-1)_BOT.

The (n-1)-th upper link line HLIA_DATA(n-1)_TOP may be arranged in the upper display area DA_TOP, the (n-1)-th lower link line HLIA_DATA(n-1)_BOT may be arranged in the lower display area DA_BOT, and the (n-1)-th middle link line VLIA_DATA(n-1) may pass through the middle display area DA_MID in the first direction.

As described above, the plurality of data lines DL may be classified into a first data line group GR1 having a bypass link line bypassing the waist area WA within the display area DA, and a second data line group GR2 extending in the first direction in a straight line shape and not having a bypass link line because there is no need to bypass the waist area WA within the display area DA.

Since the data lines DL included in the first data line group GR1 include a bypass link line, the data lines DL included in the first data line group GR1 may be arranged in a form that is not a straight line or a substantially straight line, but rather in a curved form or a bent form by the bypass link line. For example, a first data line group GR1 may include an n-th data line DL(n), an (n-1)-th data line DL(n-1), etc. Here, n may be a natural number greater than or equal to 1.

Since the data lines DL included in the second data line group GR2 do not include a bypass link line, the data lines DL included in the second data line group GR2 may be arranged in a straight line or a substantially straight line. The data lines DL included in the second data line group GR2 may pass through the upper display area DA_TOP, the middle display area DA_MID, and the lower display area DA_BOT while extending in the first direction. For example, the second data line group GR2 may include an (n+a)-th data line DL(n+a), an (n+a+1)-th data line DL(n+a+1), and an (n+a+2)th data line DL(n+a+2). Here, n may be a natural number greater than or equal to 1, and 'a' may be a natural number greater than or equal to 1.

Referring to FIG. 6 and FIG. 7, the display area DA may include an upper link area HLIA_TOP_ZONE in which the upper link lines are arranged, incluing the n-th upper link line HLIA_DATA(n)_TOP and the (n-1)-th upper link line HLIA_DATA(n-1)_TOP, a lower link area HLIA_BOT_ZONE in which the lower link lines are arranged, including the n-th lower link line HLIA_DATA(n)_BOT and the (n-1)-th lower link line HLIA_DATA(n-1)_BOT, and a middle link area VLIA_ZONE in which the middle link lines are arranged, including the n-th middle link line VLIA_DATA(n) and the (n-1)-th middle link line VLIA_DATA(n-1).

The upper link area HLIA_TOP_ZONE may be included in the upper display area DA_TOP. The lower link area HLIA_BOT_ZONE may be included in the lower display area DA_BOT. The middle link area VLIA_ZONE may be included in the upper display area DA_TOP, the middle display area DA_MID, and the lower display area DA_BOT.

For example, the upper link area HLIA_TOP_ZONE may have a first triangular shape, the lower link area HLIA_BOT_ZONE may have a second triangular shape, and the middle link area VLIA_ZONE may have a quadrilateral shape.

For example, the first triangular shape of the upper link area HLIA_TOP_ZONE and the second triangular shape of the lower link area HLIA_BOT_ZONE may be symmetrical to each other with respect to the middle display area DA_MID. The middle link area VLIA_ZONE may have a trapezoidal shape.

Referring to FIG. 6 and FIG. 8, the display panel 110 according to the embodiments of the present disclosure may further include power lines VSSL arranged in a mesh form and disposed in a display area DA. For example, the power lines VSSL may be base voltage lines VSSL that transmit a base voltage VSS to sub-pixels SP. The base voltage VSS may be a type of common voltage whose voltage level is constant over time.

Since the power lines VSSL are arranged in a mesh form within the display area DA, the resistance of the power lines VSSL may be reduced. Accordingly, power may be stably supplied to the sub-pixels through the power lines VSS, and the display driving performance may be improved.

The power lines VSSL may include a plurality of horizontal power lines HLIA_VSS and a plurality of vertical power lines VLIA_VSS.

The plurality of horizontal power lines HLIA_VSS may include a plurality of upper horizontal power lines HLIA_VSS_TOP and a plurality of lower horizontal power lines HLIA_VSS_BOT. The plurality of vertical power lines VLIA_VSS may include a plurality of upper vertical power lines VLIA_VSS_TOP and a plurality of lower vertical power lines VLIA_VSS_BOT.

Referring to FIGS. 6 to 8, each of the plurality of upper horizontal power lines HLIA_VSS_TOP may be positioned in the upper display area DA_TOP, spaced apart from the n-th upper link line HLIA_DATA(n)_TOP in the same row as the n-th upper link line HLIA_DATA(n)_TOP, and may be arranged to extend in the second direction.

Each of the plurality of upper vertical power lines VLIA_VSS_TOP may be positioned in the upper display area DA_TOP, spaced apart from the n-th middle link line VLIA_DATA(n) in the same column as the n-th middle link line VLIA_DATA(n), and may be arranged to extend in the first direction.

Each of the plurality of lower horizontal power lines HLIA_VSS_BOT may be positioned in the lower display area DA_BOT,spaced apart from the n-th lower link line HLIA_DATA(n)_BOT in the same row as the n-th lower link line HLIA_DATA(n)_BOT, and may be arranged to extend in the second direction.

Each of the plurality of lower vertical power lines VLIA_VSS_BOT may be positioned in the lower display area DA_BOT,spaced apart from the n-th middle link line VLIA_DATA(n) in the same column as the n-th middle link line VLIA_DATA(n), and may be arranged to extend in the first direction.

Referring to FIGS. 6 to 8, the upper horizontal power line HLIA_VSS_TOP may intersect with the (n-1)-th middle link line VLIA_DATA(n-1). The upper vertical power line VLIA_VSS_TOP may intersect with the (n-1)-th upper link line HLIA_DATA(n-1)_TOP. The lower horizontal power line HLIA_VSS_BOT may intersect with the (n-1)-th middle link line VLIA_DATA(n-1). The lower vertical power line VLIA_VSS_BOT may intersect with the (n-1)-th lower link line HLIA_DATA(n-1)_BOT.

The (n-1)-th upper data line DL(n-1)_TOP may be arranged on the side (e.g., the left side) of the n-th upper data line DL(n)_TOP in the second direction, and the (n-1)-th lower data line DL(n-1)_BOT may be arranged on the side (e.g., the left side) of the n-th lower data line DL(n)_BOT in the second direction.

The (n-1)-th upper link line HLIA_DATA(n-1)_TOP may be arranged on the side (e.g., the upper side) of the n-th upper link line HLIA_DATA(n)_TOP in the first direction. The (n-1)-th middle link line VLIA_DATA(n-1) may be arranged on the side (e.g., the right side) of the n-th middle link line VLIA_DATA(n) in the second direction. The (n-1)-th lower link line HLIA_DATA(n-1)_BOT may be arranged on the side (e.g., the lower side) of the n-th lower link line HLIA_DATA(n)_BOT in the first direction.

Each of the upper vertical power line VLIA_VSS_TOP and the lower vertical power line VLIA_VSS_BOT may be arranged between two adjacent data lines among the plurality of data lines DL.

As described above, the substrate 111 may include a waist area WA that is dug inwardly. In this regard, the plurality of data lines DL may be classified into a first data line group GR1 having a bypass link line DL_BLL that bypasses the waist area WA within the display area DA, and a second data line group GR2 that is arranged in a straight line shape in the first direction without bypassing the waist area WA within the display area DA and does not have a bypass link line DL_BLL.

The first data line group GR1 may include an n-th data line DL(n) and an (n-1)-th data line DL(n-1). The second data line group GR2 may pass through the upper display area DA_TOP, the middle display area DA_MID, and the lower display area DA_BOT while extending in the first direction.

As described above, the first data line group GR1 and the second data line group GR2 have different line shapes and line arrangements, and may also be formed in different metal layers. For example, a plurality of data lines DL in the first data line group GR1 may be composed of two or more metal layers. A plurality of data lines DL in the second data line group GR2 may be composed of one metal layer.

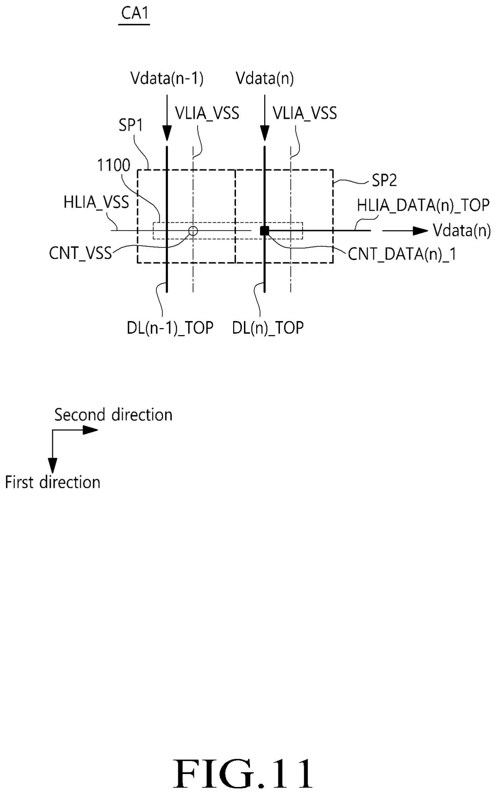

FIGS. 11 to 14 are enlarged plan views of the first to fourth connection areas CA1, CA2, CA3, and CA4 in the first area A1 and the second area A2 of the display panel 110 according to embodiments of the present disclosure.

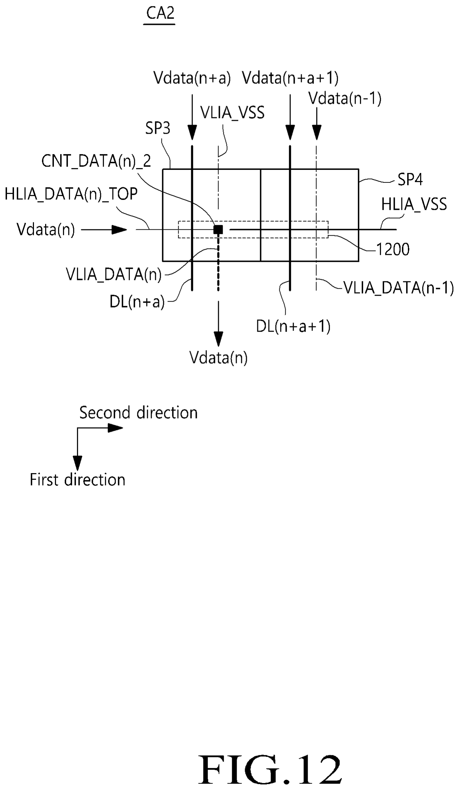

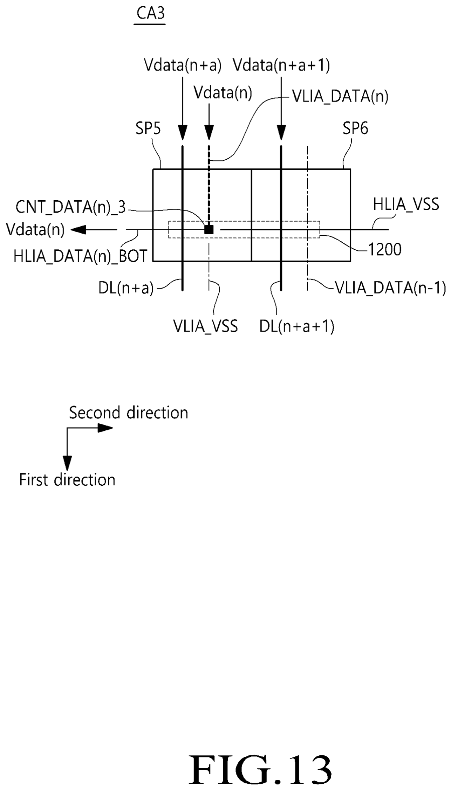

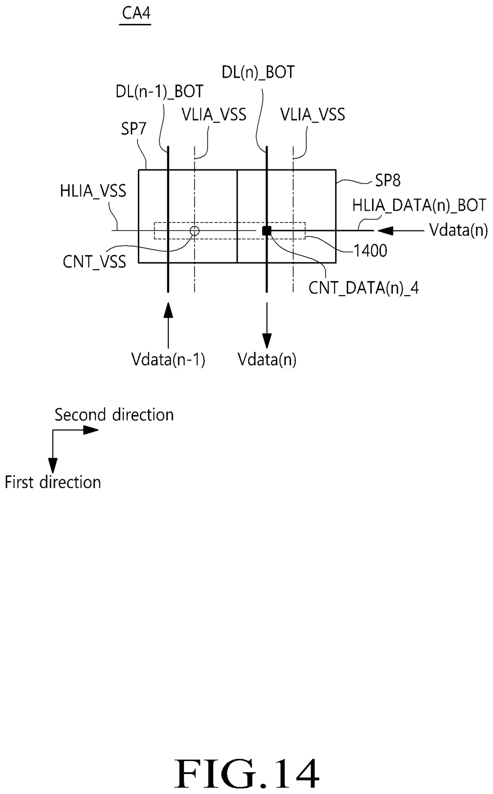

FIG. 11 is an enlarged plan view of the first connection area CA1 in the first area A1 of FIG. 6, FIG. 12 is an enlarged plan view of the second connection area CA2 in the first area A1 of FIG. 6, FIG. 13 is an enlarged plan view of the third connection area CA3 in the second area A2 of FIG. 6, and FIG. 14 is an enlarged plan view of the fourth connection area CA4 in the second area A2 of FIG. 6.

Referring to FIG. 11, in the first connection area CA1, the (n-1)-th upper data line DL(n-1) _TOP and the n-th upper data line DL(n)_TOP may be arranged to extend in the first direction (e.g., vertical direction). An (n-1)-th data signal Vdata(n-1) may be applied to the (n-1)-th upper data line DL(n-1)_TOP, and an n-th data signal Vdata(n) may be applied to the n-th upper data line DL(n)_TOP.

A vertical power line VLIA_VSS extending in a first direction may be arranged on each side of the (n-1)-th upper data line DL(n-1)_TOP and the n-th upper data line DL(n)_TOP. The vertical power line VLIA_VSS extending in the first direction may be arranged between the (n-1)-th upper data line DL(n-1)_TOP and the n-th upper data line DL(n)_TOP.

A horizontal power line HLIA_VSS and an n-th upper link line HLIA_DATA(n)_TOP may be arranged in the second direction (e.g., horizontal direction). The horizontal power line HLIA_VSS and the n-th upper link line HLIA_DATA(n)_TOP may be arranged on the same line (or same row), and may be spaced apart from each other. The horizontal power line HLIA_VSS and the n-th upper link line HLIA_DATA(n)_TOP may be arranged within the same metal layer.

The horizontal power line HLIA_VSS may intersect with the (n-1)-th upper data line DL(n-1) _TOP and the vertical power line VLIA_VSS.

The horizontal power line HLIA_VSS and the vertical power line VLIA_VSS may be electrically connected through a power connection point CNT_VSS. The horizontal power line HLIA_VSS and the vertical power line VLIA_VSS may be arranged in different metal layers.

The n-th upper link line HLIA_DATA(n)_TOP may intersect the n-th upper data line DL(n)_TOP and the vertical power line VLIA_VSS.

The n-th upper data line DL(n)_TOP may be electrically connected to the n-th upper link line HLIA_DATA(n)_TOP at a first connection point CNT_DATA(n)_1. The n-th upper data line DL(n)_TOP and the n-th upper link line HLIA_DATA(n)_TOP may be arranged in different metal layers.

The n-th data signal Vdata(n) input to the n-th upper data line DL(n)_TOP may be output to the n-th upper link line HLIA_DATA(n)_TOP. The n-th data signal Vdata(n) input to the n-th upper data line DL(n)_TOP may be supplied to the sub-pixels SP connected to the n-th upper data line DL(n)_TOP.

The sub-pixels SP connected to the n-th upper data line DL(n)_TOP may be located at an upper portion of the waist area WA.

Referring to FIG. 12, in the second connection area CA2, an (n+a)-th data line DL(n+a) and an (n+a+1)-th data line DL(n+a+1) may be arranged to extend in the first direction. The (n+a)-th data line DL(n+a) may be applied with an (n+a)-th data signal Vdata(n+a), and the (n+a+1)-th data line DL(n+a+1) may be applied with an (n+a+1)-th data signal Vdata(n+a+1).

The vertical power line VLIA_VSS may be arranged between the (n+a)-th data line DL(n+a) and the (n+a+1)-th data line DL(n+a+1), and may extend in the first direction.

An n-th middle link line VLIA_DATA(n) may be arranged between the (n+a)-th data line DL(n+a) and the (n+a+1)-th data line DL(n+a+1), and may extend in the first direction.

Between the (n+a)-th data line DL(n+a) and the (n+a+1)-th data line DL(n+a+1), the n-th middle link line VLIA_DATA(n) and the vertical power line VLIA_VSS may be arranged on the same line (or same column), but may be spaced apart from each other.

An (n-1)-th middle link line VLIA_DATA(n-1) may be further arranged on the side (e.g., right side) of the (n+a+1)-th data line DL(n+a+1), and may extend in the first direction.

The n-th upper link line HLIA_DATA(n)_TOP and the horizontal power line HLIA_VSS may each be arranged in the second direction. The n-th upper link line HLIA_DATA(n)_TOP and the horizontal power line HLIA_VSS are arranged on the same line (e.g., same row), and may be spaced from each other. The n-th upper link line HLIA_DATA(n)_TOP and the horizontal power line HLIA_VSS may be arranged within the same metal layer.

The n-th upper link line HLIA_DATA(n)_TOP may intersect with the (n+a)-th data line DL(n+a) and the vertical power line VLIA_VSS.

The n-th upper link line HLIA_DATA(n)_TOP may be electrically connected to the n-th middle link line VLIA_DATA(n) at a second connection point CNT_DATA(n)_2.The n-th upper link line HLIA_DATA(n)_TOP and the n-th middle link line VLIA_DATA(n) may be arranged in different metal layers.

The n-th data signal Vdata(n) input to the n-th upper link line HLIA_DATA(n)_TOP may be output to the n-th middle link line VLIA_DATA(n).

The horizontal power line HLIA_VSS may intersect with the (n+a+1)-th data line DL(n+a+1) and the (n-1)-th middle link line VLIA_DATA(n-1). The horizontal power line HLIA_VSS may be arranged in a different metal layer from the (n+a+1)-th data line DL(n+a+1) and the (n-1)-th middle link line VLIA_DATA(n-1). The horizontal power line HLIA_VSS may be electrically isolated from the (n+a+1)-th data line DL(n+a+1) and the (n-1)-th middle link line VLIA_DATA(n-1).

Referring to FIG. 13, in the third connection area CA3, the (n+a)-th data line DL(n+a) and the (n+a+1)-th data line DL(n+a+1) may be arranged to extend in the first direction. The (n+a)-th data signal Vdata(n+a) may be applied to the (n+a)-th data line DL(n+a), and the (n+a+1)-th data signal Vdata(n+a+1) may be applied to the (n+a+1)-th data line DL(n+a+1).

The n-th middle link line VLIA_DATA(n) may be arranged between the (n+a)-th data line DL(n+a) and the (n+a+1)-th data line DL(n+a+1), and may extend in the first direction.

The vertical power line VLIA_VSS is arranged between the (n+a)-th data line DL(n+a) and the (n+a+1)-th data line DL(n+a+1), and may extend in the first direction.

Between the (n+a)-th data line DL(n+a) and the (n+a+1)-th data line DL(n+a+1), the n-th middle link line VLIA_DATA(n) and the vertical power line VLIA_VSS may be arranged on the same line (e.g., same column), but may be spaced apart from each other.

The (n-1)-th middle link line VLIA_DATA(n-1) may be further arranged on the side (e.g., right side) of the (n+a+1)-th data line DL(n+a+1), and may extend in the first direction.

The n-th lower link line HLIA_DATA(n)_BOT and the horizontal power line HLIA_VSS may each be arranged in the second direction. The n-th lower link line HLIA_DATA(n)_BOT and the horizontal power line HLIA_VSS may be arranged on the same line (e.g., same row), and may be spaced apart from each other. The n-th lower link line HLIA_DATA(n)_BOT and the horizontal power line HLIA_VSS may be arranged within the same metal layer.

The n-th lower link line HLIA_DATA(n)_BOT may intersect with the (n+a)-th data line DL(n+a) and the n-th middle link line VLIA_DATA(n).

The n-th lower link line HLIA_DATA(n)_BOT may be electrically connected to the n-th middle link line VLIA_DATA(n) at a third connection point CNT_DATA(n)_3. The n-th lower link line HLIA_DATA(n)_BOT and the n-th middle link line VLIA_DATA(n) may be arranged in different metal layers.

The n-th data signal Vdata(n) input to the n-th middle link line VLIA_DATA(n) may be output to the n-th lower link line HLIA_DATA(n)_BOT.

The horizontal power line HLIA_VSS may intersect with (or cross) the (n+a+1)-th data line DL(n+a+1) and the (n-1)-th middle link line VLIA_DATA(n-1). The horizontal power line HLIA_VSS may be arranged within a different metal layer from the (n+a+1)-th data line DL(n+a+1) and the (n-1)-th middle link line VLIA_DATA(n-1). The horizontal power line HLIA_VSS may be electrically isolated from the (n+a+1)-th data line DL(n+a+1) and the (n-1)-th middle link line VLIA_DATA(n-1).

Referring to FIG. 14, in the fourth connection area CA4, the (n-1)-th lower data line DL(n-1)_BOT and the n-th lower data line DL(n)_BOT may be arranged to extend in the first direction (e.g., vertical direction). The (n-1)-th lower data line DL(n-1)_BOT may be supplied with the (n-1)-th data signal Vdata(n-1), and the n-th lower data line DL(n)_BOT may be supplied with the n-th data signal Vdata(n).

A vertical power line VLIA_VSS extending in the first direction may be arranged on each side of the (n-1)-th lower data line DL(n-1) _BOT and the n-th lower data line DL(n)_BOT. The vertical power line VLIA_VSS extending in the first direction may be arranged between the (n-1)-th lower data line DL(n-1)_BOT and the n-th lower data line DL(n)_BOT.

The horizontal power line HLIA_VSS and the n-th lower link line HLIA_DATA(n)_BOT may be arranged in the second direction (e.g., horizontal direction). The horizontal power line HLIA_VSS and the n-th lower link line HLIA_DATA(n)_BOT may be arranged on the same line (e.g., same row), and may be spaced apart from each other. The horizontal power line HLIA_VSS and the n-th lower link line HLIA_DATA(n)_BOT may be arranged within the same metal layer.

The horizontal power line HLIA_VSS may intersect with (or cross) the (n-1)-th lower data line DL(n-1) _BOT and the vertical power line VLIA_VSS.

The horizontal power line HLIA_VSS and the vertical power line VLIA_VSS may be electrically connected through a power connection point CNT_VSS. The horizontal power line HLIA_VSS and the vertical power line VLIA_VSS may be arranged within different metal layers.

The n-th lower link line HLIA_DATA(n)_BOT may intersect with the n-th lower data line DL(n)_BOT and the vertical power line VLIA_VSS.

The n-th lower link line HLIA_DATA(n)_BOT may be electrically connected to the n-th lower data line DL(n)_BOT at a fourth connection point CNT_DATA(n)_4. The n-th lower link line HLIA_DATA(n)_BOT and the n-th lower data line DL(n)_BOT may be arranged in different metal layers.

The n-th data signal Vdata(n) input to the n-th lower link line HLIA_DATA(n)_BOT may be output to the n-th lower data line DL(n)_BOT. The n-th data signal Vdata(n) input to the n-th lower data line DL(n)_BOT may be supplied to the sub-pixels SP connected to the n-th lower data line DL(n)_BOT.

Sub-pixels SP connected to the n-th lower data line DL(n)_BOT may be located at a lower portion of the waist area WA.

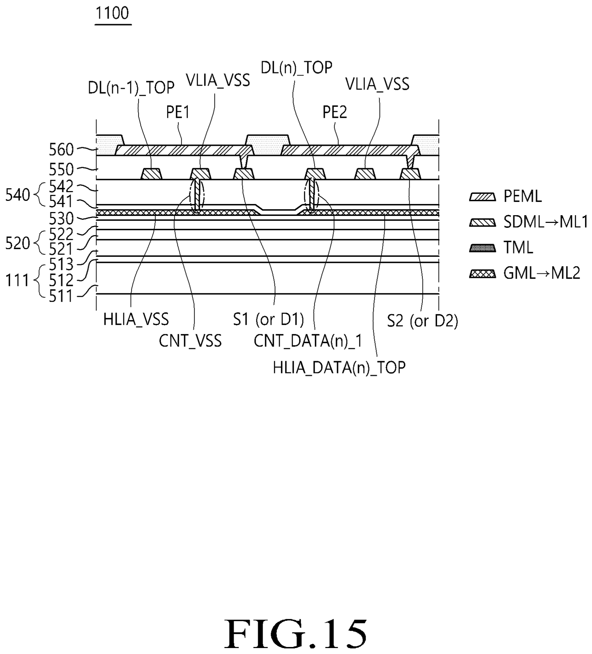

FIGS. 15 to 18 are cross-sectional views of first to fourth main areas 1100, 1200, 1300, and 1400 in the first to fourth connection areas CA1, CA2, CA3, and CA4.

The stacked structure in the cross-sectional views of FIGS. 15 to 18 may be same as the stacked structure in the cross-sectional view of FIG. 5. Therefore, the description of the same stacked structure in the cross-sectional view of FIG. 5 may be omitted.

The signal lines extending in the first direction (e.g., vertical direction) and the signal lines extending in the second direction (e.g., horizontal direction) may be arranged in different metal layers.

The signal lines extending in the first direction (e.g., vertical direction) may be arranged within a first metal layer, and the signal lines extending in the second direction (e.g., horizontal direction) may be arranged within a second metal layer different from the first metal layer.

Referring to FIGS. 15 to 18, the n-th upper data line DL(n)_TOP, the n-th lower data line DL(n)_BOT, and the n-th middle link line VLIA_DATA(n) may be arranged within the first metal layer ML1. However, in the following description, FIG. 5 and FIGS. 11 to 14 are referred to together, and any description that overlaps with the descriptions in FIG. 5 and FIGS. 11 to 14 may be omitted.

Referring to FIGS. 15 to 18, the n-th upper link line HLIA_DATA(n)_TOP and the n-th lower link line HLIA_DATA(n)_BOT may be arranged in the second metal layer ML2. The second metal layer ML2 may be a different metal layer from the first metal layer ML1. For example, the second metal layer ML2 may be a metal layer closer to the substrate 111 than the first metal layer ML1. For another example, the second metal layer ML2 may be a metal layer further away from the substrate 111 than the first metal layer ML1.

Referring to FIGS. 15 to 18, an upper vertical power line VLIA_VSS_TOP and a lower vertical power line VLIA_VSS _BOT may be arranged within the first metal layer ML1 together with the n-th upper data line DL(n)_TOP, the n-th lower data line DL(n)_BOT, and the n-th middle link line VLIA_DATA(n).

Referring to FIGS. 15 to 18, an upper horizontal power line HLIA_VSS_TOP and a lower horizontal power line HLIA_VSS_BOT may be arranged within the second metal layer ML2 different from the first metal layer ML1 together with the n-th upper link line HLIA_DATA(n)_TOP and the n-th lower link line HLIA_DATA(n)_BOT.

Among the first metal layer ML1 and the second metal layer ML2, one may be a source-drain metal layer SDML on which a source electrode or a drain electrode of a transistor in the display area DA is disposed, and the other may be a gate metal layer GML on which a gate electrode of a transistor in the display area DA is disposed.

As an example, the first metal layer ML1 may be a source-drain metal layer SDML, and the second metal layer ML2 may be a gate metal layer GML. As another example, the first metal layer ML1 may be a gate metal layer GML, and the second metal layer ML2 may be a source-drain metal layer SDML. In FIGS. 15 to 18, it is exemplified a case in which the first metal layer ML1 is a source-drain metal layer SDML, and the second metal layer ML2 is a gate metal layer GML.

The source-drain metal layer SDML corresponding to the first metal layer ML1 may be positioned between an interlayer insulating layer 540 and a planarization layer 550.

The gate metal layer GML corresponding to the second metal layer ML2 may be positioned between a gate insulating layer 530 and the interlayer insulating layer 540.

Referring to FIG. 15, the (n-1)-th upper data line DL(n-1)_TOP and the n-th upper data line DL(n)_TOP may be arranged on the interlayer insulating layer 540.

The (n-1)-th upper data line DL(n-1)_TOP and the n-th upper data line DL(n)_TOP may overlap with a first pixel electrode PE1 of a first sub-pixel and a second pixel electrode PE2 of a second sub-pixel, respectively.

The first pixel electrode PE1 of the first sub-pixel and the second pixel electrode PE2 of the second sub-pixel may be disposed on the planarization layer 550. A bank 560 may be disposed on a portion of the upper portion of each of the first pixel electrode PE1 of the first sub-pixel and the second pixel electrode PE2 of the second sub-pixel.

The first pixel electrode PE1 of the first sub-pixel may be electrically connected to a first source electrode S1 or a first drain electrode D1 of a first transistor of the first sub-pixel. The second pixel electrode PE2 of the second sub-pixel may be electrically connected to a second source electrode S2 or a second drain electrode D2 of a second transistor of the second sub-pixel.

The (n-1)-th upper data line DL(n-1)_TOP and the n-th upper data line DL(n)_TOP may be disposed together within a source-drain metal layer SDML corresponding to the first metal layer ML1.

The source-drain metal layer SDML corresponding to the first metal layer ML1 may be a metal layer on which the first source electrode S1 or the first drain electrode D1 of the first transistor of the first sub-pixel and the second source electrode S2 or the second drain electrode D2 of the second transistor of the second sub-pixel are disposed.

The vertical power line VLIA_VSS may be arranged together with the (n-1)-th upper data line DL(n-1) _TOP and the n-th upper data line DL(n)_TOP within the source-drain metal layer SDML corresponding to the first metal layer ML1.

The horizontal power line HLIA_VSS and the n-th upper link line HLIA_DATA(n)_TOP may be arranged together within the gate metal layer GML corresponding to the second metal layer ML2.

The gate metal layer GML corresponding to the second metal layer ML2 may be a metal layer on which a first gate electrode of the first transistor of the first sub-pixel and a second gate electrode of the second transistor of the second sub-pixel are disposed.

The n-th upper data line DL(n)_TOP may be electrically connected to the n-th upper link line HLIA_DATA(n)_TOP through a first contact hole of the interlayer insulating layer 540. The first contact hole of the interlayer insulating layer 540 may be located at a first connection point CNT_DATA(n)_1.

The vertical power line VLIA_VSS may be electrically connected to the horizontal power line HLIA_VSS through a first power contact hole of the interlayer insulating layer 540. The first power contact hole of the interlayer insulating layer 540 may be located at a first power connection point CNT_VSS.

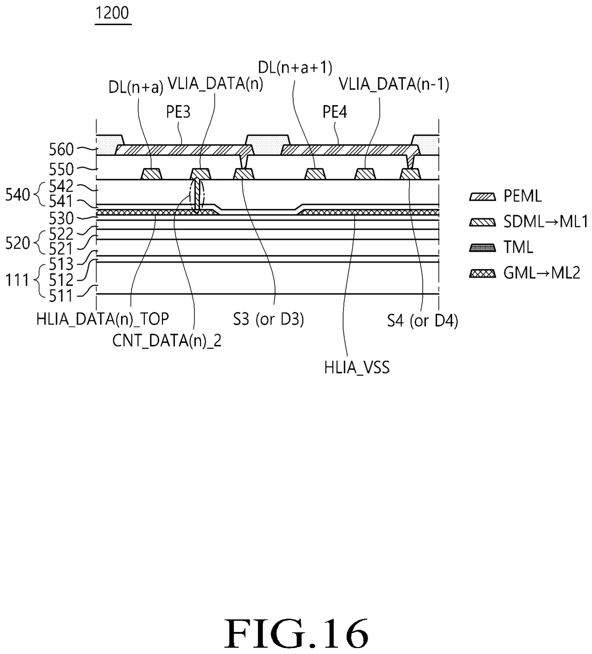

Referring to FIG. 16, an n-th middle link line VLIA_DATA(n), an (n-1)-th middle link line VLIA_DATA(n-1), an (n+a)-th data line DL(n+a), and an (n+a+1)-th data line DL(n+a+1) may be arranged on the interlayer insulating layer 540.

The n-th middle link line VLIA_DATA(n) and the (n-1)-th middle link line VLIA_DATA(n-1) may overlap with a third pixel electrode PE3 of a third sub-pixel and a fourth pixel electrode PE4 of a fourth sub-pixel, respectively.

The third pixel electrode PE3 of the third sub-pixel and the fourth pixel electrode PE4 of the fourth sub-pixel may be disposed on the planarization layer 550. A bank 560 may be disposed on a portion of the upper portion of each of the third pixel electrode PE3 of the third sub-pixel and the fourth pixel electrode PE4 of the fourth sub-pixel.

The third pixel electrode PE3 of the third sub-pixel may be electrically connected to a third source electrode S3 or a third drain electrode D3 of a third transistor of the third sub-pixel. The fourth pixel electrode PE4 of the fourth sub-pixel may be electrically connected to a fourth source electrode S4 or a fourth drain electrode D4 of a fourth transistor of the fourth sub-pixel.

The n-th middle link line VLIA_DATA(n) and the (n-1)-th middle link line VLIA_DATA(n-1) may be arranged together in a source-drain metal layer SDML corresponding to the first metal layer ML1.

The source-drain metal layer SDML corresponding to the first metal layer ML1 may be a metal layer on which the third source electrode S3 or the third drain electrode D3 of the third transistor of the third sub-pixel and the fourth source electrode S4 or the fourth drain electrode D4 of the fourth transistor of the fourth sub-pixel are disposed.

The (n+a)-th data line DL(n+a) and the (n+a+1)-th data line DL(n+a+1) may be arranged together with the n-th middle link line VLIA_DATA(n) and the (n-1)-th middle link line VLIA_DATA(n-1) within a source-drain metal layer SDML corresponding to the first metal layer ML1.

The n-th upper link line HLIA_DATA(n)_TOP and the horizontal power line HLIA_VSS may be arranged together within a gate metal layer GML corresponding to the second metal layer ML2.

The gate metal layer GML corresponding to the second metal layer ML2 may be a metal layer on which a third gate electrode of the third transistor of the third sub-pixel and a fourth gate electrode of the fourth transistor of the fourth sub-pixel are disposed.

The n-th middle link line VLIA_DATA(n) may be electrically connected to the n-th upper link line HLIA_DATA(n)_TOP through a second contact hole of the interlayer insulation layer 540. The second contact hole of the interlayer insulation layer 540 may be located at a second connection point CNT_DATA(n)_2.

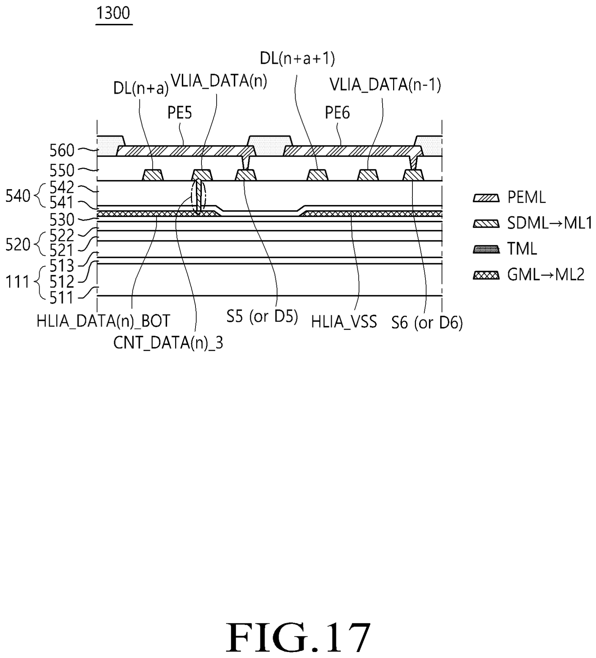

Referring to FIG. 17, the n-th middle link line VLIA_DATA(n), the (n-1)-th middle link line VLIA_DATA(n-1), the (n+a)-th data line DL(n+a), and the (n+a+1)-th data line DL(n+a+1) may be arranged on the interlayer insulation layer 540.

The n-th middle link line VLIA_DATA(n) and the (n-1)-th middle link line VLIA_DATA(n-1) may overlap with a fifth pixel electrode PE5 of a fifth sub-pixel and a sixth pixel electrode PE6 of a sixth sub-pixel, respectively.

The fifth pixel electrode PE5 of the fifth sub-pixel and the sixth pixel electrode PE6 of the sixth sub-pixel may be disposed on the planarization layer 550. A bank 560 may be disposed on a portion of the upper portion of each of the fifth pixel electrode PE5 of the fifth sub-pixel and the sixth pixel electrode PE6 of the sixth sub-pixel.

The fifth pixel electrode PE5 of the fifth sub-pixel may be electrically connected to a fifth source electrode S5 or a fifth drain electrode D5 of a fifth transistor of the fifth sub-pixel. The sixth pixel electrode PE6 of the sixth sub-pixel may be electrically connected to a sixth source electrode S6 or a sixth drain electrode D6 of a sixth transistor of the sixth sub-pixel.

The n-th middle link line VLIA_DATA(n) and the (n-1)-th middle link line VLIA_DATA(n-1) may be arranged together in a source-drain metal layer SDML corresponding to the first metal layer ML1.

The source-drain metal layer SDML corresponding to the first metal layer ML1 may be a metal layer on which the fifth source electrode S5 or the fifth drain electrode D5 of the fifth transistor of the fifth sub-pixel and the sixth source electrode S6 or the sixth drain electrode D6 of the sixth transistor of the sixth sub-pixel are disposed.

The (n+a)-th data line DL(n+a) and the (n+a+1)-th data line DL(n+a+1) may be arranged together with the n-th middle link line VLIA_DATA(n) and the (n-1)-th middle link line VLIA_DATA(n-1) within a source-drain metal layer SDML corresponding to the first metal layer ML1.

The n-th lower link line HLIA_DATA(n)_BOT and the horizontal power line HLIA_VSS may be arranged together within a gate metal layer GML corresponding to the second metal layer ML2.

The gate metal layer GML corresponding to the second metal layer ML2 may be a metal layer on which a fifth gate electrode of the fifth transistor of the fifth sub-pixel and a sixth gate electrode of the sixth transistor of the sixth sub-pixel are disposed.

The n-th middle link line VLIA_DATA(n) may be electrically connected to the n-th lower link line HLIA_DATA(n)_BOT through a third contact hole of the interlayer insulating layer 540. The third contact hole of the interlayer insulating layer 540 may be located at a third connection point CNT DATA(n) _3.

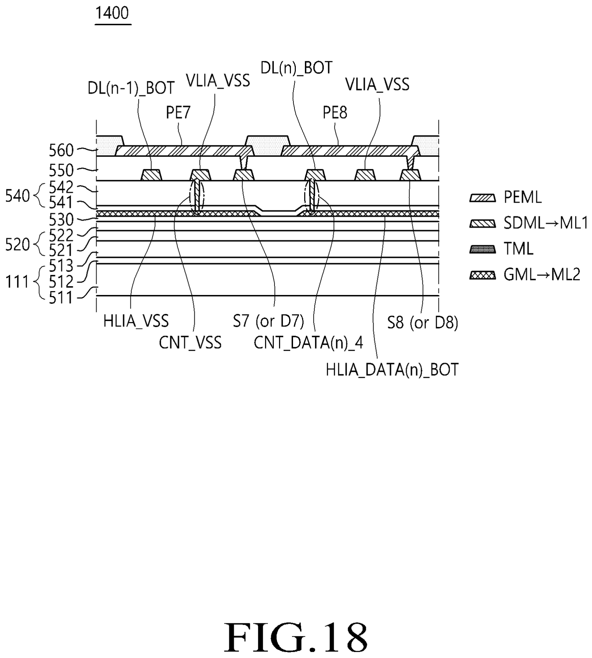

Referring to FIG. 18, the (n-1)-th lower data line DL(n-1)_BOT and the n-th lower data line DL(n)_BOT may be arranged on the interlayer insulating layer 540.

The (n-1)-th lower data line DL(n-1)_BOT and the n-th lower data line DL(n)_BOT may overlap with a seventh pixel electrode PE7 of a seventh sub-pixel and an eighth pixel electrode PE8 of an eighth sub-pixel, respectively.

The seventh pixel electrode PE7 of the seventh sub-pixel and the eighth pixel electrode PE8 of the eighth sub-pixel may be disposed on the planarization layer 550. A bank 560 may be disposed on a portion of the upper portion of each of the seventh pixel electrode PE7 of the seventh sub-pixel and the eighth pixel electrode PE8 of the eighth sub-pixel, respectively.

The seventh pixel electrode PE7 of the seventh sub-pixel may be electrically connected to a seventh source electrode S7 or a seventh drain electrode D7 of a seventh transistor of the seventh sub-pixel. The eighth pixel electrode PE8 of the eighth sub-pixel may be electrically connected to an eighth source electrode S8 or an eighth drain electrode D8 of an eighth transistor of the eighth sub-pixel.

The (n-1)-th lower data line DL(n-1)_BOT and the n-th lower data line DL(n)_BOT may be arranged together within a source-drain metal layer SDML corresponding to the first metal layer ML1. Here, the source-drain metal layer SDML corresponding to the first metal layer ML1 may be a metal layer on which the seventh source electrode S7 or the seventh drain electrode D7 of the seventh transistor of the seventh sub-pixel and the eighth source electrode S8 or the eighth drain electrode D8 of the eighth transistor of the eighth sub-pixel are disposed.

The vertical power line VLIA_VSS may be arranged within the source-drain metal layer SDML corresponding to the first metal layer ML1 together with the (n-1)-th lower data line DL(n-1) _BOT and the n-th lower data line DL(n)_BOT.

The horizontal power line HLIA_VSS and the n-th lower link line HLIA_DATA(n)_BOT may be arranged together in a gate metal layer GML corresponding to the second metal layer ML2. Here, the gate metal layer GML corresponding to the second metal layer ML2 may be a metal layer on which a seventh gate electrode of the seventh transistor of the seventh sub-pixel and an eighth gate electrode of the eighth transistor of the eighth sub-pixel are disposed.

The n-th lower data line DL(n)_BOT may be electrically connected to the n-th lower link line HLIA_DATA(n)_BOT through a fourth contact hole of the interlayer insulating layer 540. The fourth contact hole of the interlayer insulating layer 540 may be located at a fourth connection point CNT DATA(n) _4.

The vertical power line VLIA_VSS may be electrically connected to the horizontal power line HLIA_VSS through a fourth power contact hole of the interlayer insulation layer 540. The fourth power contact hole of the interlayer insulation layer 540 may be located at a fourth power connection point CNT_VSS.

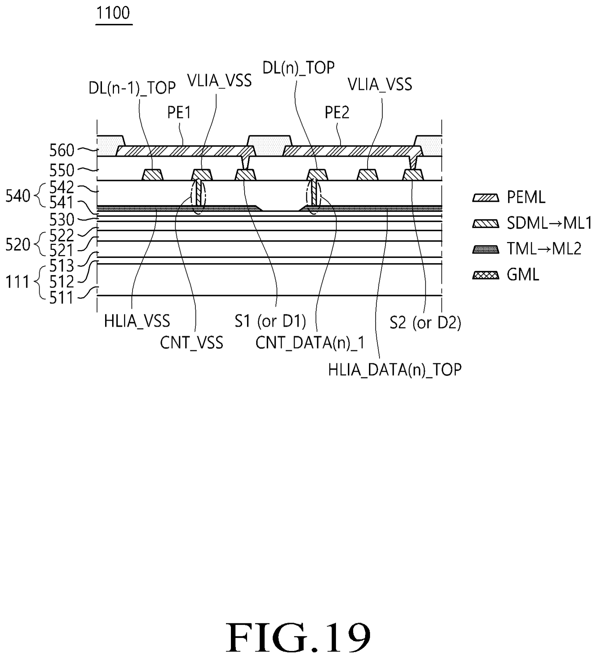

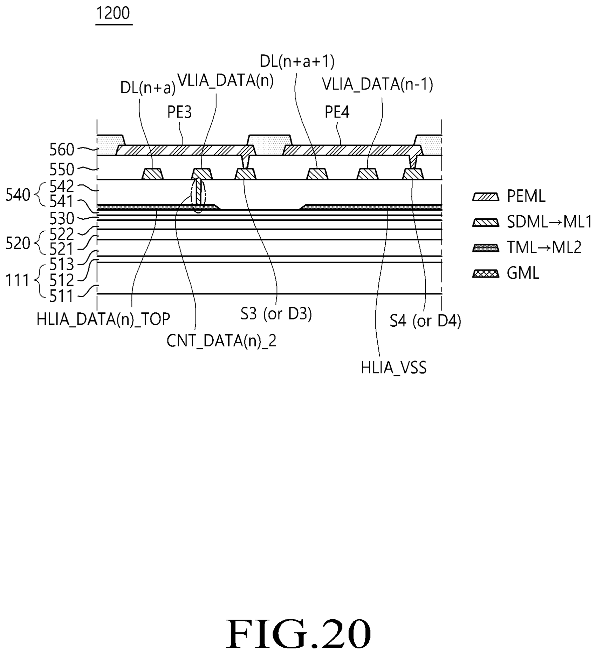

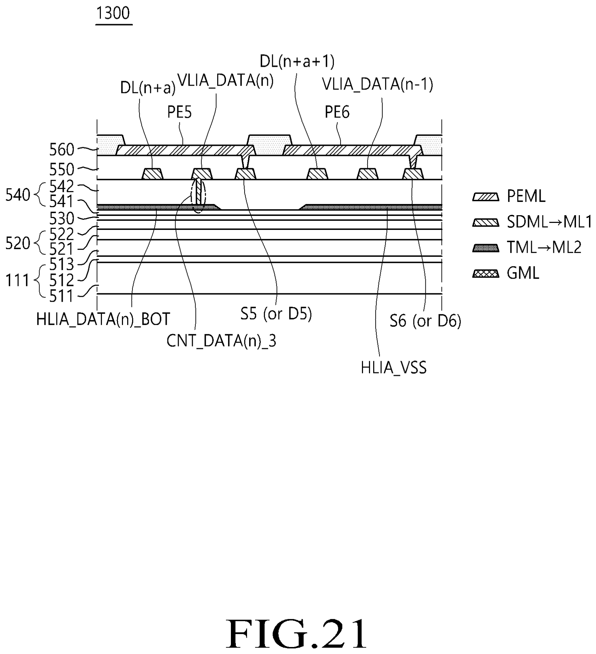

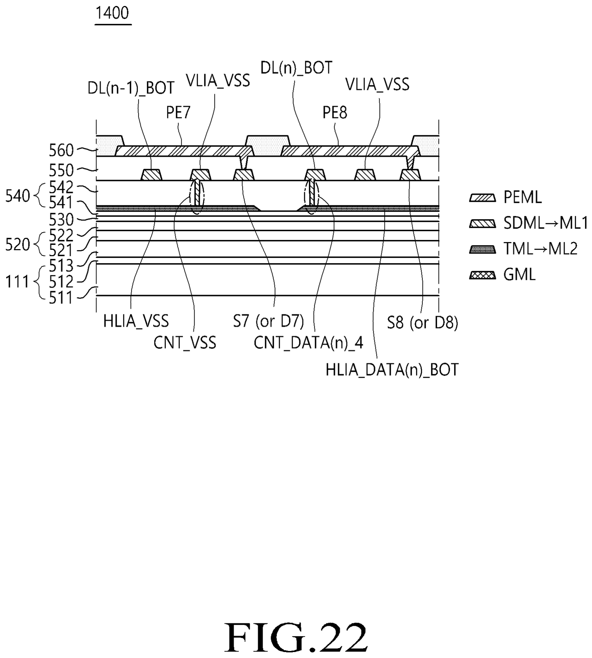

FIGS. 19 to 22 are cross-sectional views of the first to fourth main areas in the first to fourth connection areas.

Referring to FIGS. 19 to 22, the n-th upper data line DL(n)_TOP, the n-th lower data line DL(n)_BOT, and the n-th middle link line VLIA_DATA(n) may be arranged within a first metal layer ML1.

Referring to FIGS. 19 to 22, the n-th upper link line HLIA_DATA(n)_TOP and the n-th lower link line HLIA_DATA(n)_BOT may be arranged in a second metal layer ML2 different from the first metal layer ML1.

The cross-sectional views of FIGS. 19 to 22 may correspond to the cross-sectional views of FIGS. 15 to 18, respectively, and are the same except that the type of the second metal layer ML2 in which the signal lines (e.g., horizontal lines) extending in the second direction are arranged is different. Therefore, the same description as in the cross-sectional views of FIGS. 15 to 18 may be omitted.

Referring to FIGS. 19 to 22, an upper vertical power line VLIA_VSS_TOP and a lower vertical power line VLIA_VSS _BOT may be arranged within the first metal layer ML1 together with the n-th upper data line DL(n)_TOP, the n-th lower data line DL(n)_BOT, and the n-th middle link line VLIA_DATA(n).

Referring to FIGS. 19 to 22, the upper horizontal power line HLIA_VSS_TOP and the lower horizontal power line HLIA_VSS_BOT may be arranged in a second metal layer ML2 different from the first metal layer ML1, together with the n-th upper link line HLIA_DATA(n)_TOP and the n-th lower link line HLIA_DATA(n)_BOT.

Among the first metal layer ML1 and the second metal layer ML2, one may be a source-drain metal layer SDML on which a source electrode or a drain electrode of a transistor in the display area DA is disposed, and the other may be a capacitor electrode metal layer TML on which one of two or more capacitor electrodes constituting a storage capacitor in the display area DA is disposed.

For example, the first metal layer ML1 may be a source-drain metal layer SDML and the second metal layer ML2 may be a capacitor electrode metal layer TML. As another example, the first metal layer ML1 may be a capacitor electrode metal layer TML and the second metal layer ML2 may be a source-drain metal layer SDML. In FIGS. 19 to 22, it is exemplified a case in which the first metal layer ML1 is a source-drain metal layer SDML and the second metal layer ML2 is a capacitor electrode metal layer TML.

The source-drain metal layer SDML corresponding to the first metal layer ML1 may be located between the interlayer insulating layer 540 and the planarization layer 550. The capacitor electrode metal layer TML corresponding to the second metal layer ML2 may be located between a first interlayer insulating layer 541 and a second interlayer insulating layer 542.

The first contact hole through which the n-th upper data line DL(n)_TOP and the n-th upper link line HLIA_DATA(n)_TOP are electrically connected may be a contact hole of the second interlayer insulating layer 542.

The second contact hole through which the n-th middle link line VLIA_DATA(n) and the n-th upper link line HLIA_DATA(n)_TOP are electrically connected may be a contact hole of the second interlayer insulating layer 542.

The third contact hole through which the n-th middle link line VLIA_DATA(n) and the n-th lower link line HLIA_DATA(n)_BOT are electrically connected may be a contact hole of the second interlayer insulating layer 542.

The fourth contact hole through which the n-th lower data line DL(n)_BOT and the n-th lower link line HLIA_DATA(n)_BOT are electrically connected may be a contact hole of the second interlayer insulating layer 542.

The power contact hole through which the vertical power line VLIA_VSS and the horizontal power line HLIA_VSS are electrically connected may be a contact hole of the second interlayer insulating layer 542.

The data link structure capable of reducing the bezel according to embodiments of the present disclosure and the power line structure associated therewith have been described as above. Hereinafter, it will be briefly described again a data link structure capable of implementing the bezel reduction and a power line structure associated therewithaccording to embodiments of the present disclosure.

A display device 100 according to embodiments of the present disclosure may include a substrate 111 including a display area DA, a first signal line disposed on the substrate 111, extending in a first direction in the display area DA, and disposed within a first metal layer ML1, and a second signal line disposed on the substrate 111, extending in a second direction different from the first direction in the display area DA, and disposed within a second metal layer ML2 different from the first metal layer ML1.

The display device 100 according to the embodiments of the present disclosure may further include a third signal line disposed on the substrate 111, extending in the first direction in the display area DA, and disposed within the first metal layer ML1, a fourth signal line disposed on the substrate 111, extending in the second direction in the display area DA, and disposed within the second metal layer ML2, and a fifth signal line disposed on the substrate 111, extending in the first direction in the display area DA, and disposed within the first metal layer ML1.

The first to fifth signal lines may be electrically connected to each other. The second signal line may electrically connect the first signal line and the third signal line. The third signal line may electrically connect the second signal line and the fourth signal line. The fourth signal line may electrically connect the third signal line and the fifth signal line.

Each of the first signal line, the third signal line, and the fifth signal line may be a wiring extending in the first direction, and each of the second signal line and the fourth signal line may be a wiring extending in the second direction. Here, the first direction and the second direction may be different directions and may be relative directions to each other. For example, the first direction may be a vertical direction and the second direction may be a horizontal direction. As another example, the first direction may be a horizontal direction and the second direction may be a vertical direction. Hereinafter, for convenience of explanation, it is exemplified a case in which the first direction is a vertical direction and the second direction is a horizontal direction, however, the present disclosure is not limited thereto.

For example, in the case that the first direction is a vertical direction and the second direction is a horizontal direction, each of the first signal line, the third signal line, and the fifth signal line may be a vertical wiring extending in the first direction (e.g., vertical direction), and each of the second signal line and the fourth signal line may be a horizontal wiring extending in the second direction (e.g., horizontal direction). In another example, if the first direction is horizontal direction and the second direction is vertical direction, each of the first signal line, the third signal line, and the fifth signal line may be horizontal wiring extending in the first direction (e.g., horizontal direction), and each of the second signal line and the fourth signal line may be vertical wiring extending in the second direction (e.g., vertical direction).

For example, in FIGS. 6 to 22, the n-th upper data line DL(n)_TOP may be the first signal line, the n-th upper link line HLIA_DATA(n)_TOP may be the second signal line, the n-th middle link line VLIA_DATA(n) may be the third signal line, the n-th lower link line HLIA_DATA(n)_BOT may be the fourth signal line, and the n-th lower data line DL(n)_BOT may be the fifth signal line.

The substrate 111 may include a waist area WA that is dug or curved inwardly. The waist area WA may be located on one side of the third signal line.

For example, the display device 100 according to the embodiments of the present disclosure may be at least one wearable device among a virtual reality (VR) device, an augmented reality (AR) device, a mixed reality (MR) device, and an extended reality (XR) device.

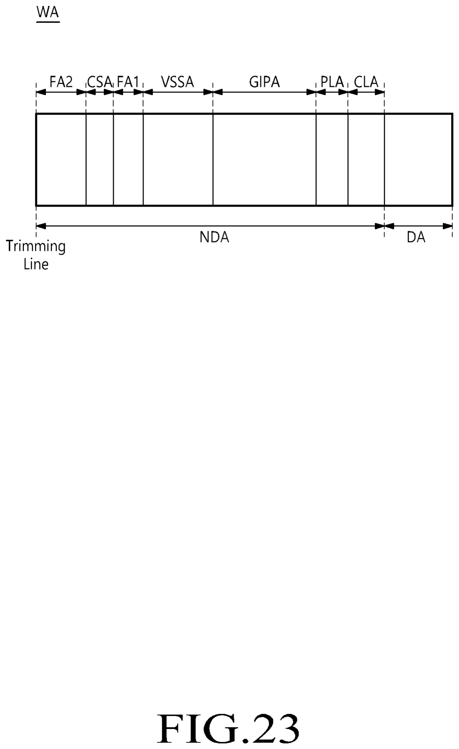

FIG. 23 illustrates detailed areas included in the waist area WA of the display panel 110 according to the embodiments of the present disclosure.

Referring to FIG. 23, if the display panel 110 according to the embodiments of the present disclosure has a data link structure capable of reducing the bezel, the data link structure may be arranged in the display area DA, and a line supplied with a data signal may not be arranged in the non-display area NDA included in the waist area WA.

If the display panel 110 according to the embodiments of the present disclosure has a data link structure capable of reducing the bezel, the non-display area NDA included in the waist area WA does not include the data link area DLLA.

If the display panel 110 according to the embodiments of the present disclosure has a data link structure capable of reducing the bezel, the non-display area NDA included in the waist area WA may include at least one of a driving power line area PLA in which driving power lines are arranged, a gate-in-panel circuit area GIPA in which a gate-in-panel circuit, which is a gate driving circuit of a gate-in-panel (GIP) type, is arranged, a base voltage line area VSSA in which a base voltage line VSSL is arranged, and a crack stopper area CSA in which a crack stopper structure is arranged.

In the driving power line area PLA, gate driving-related link lines connected to the gate-in-panel circuit and driving power lines for transmitting various driving powers (e.g., initialization voltage, reference voltage, etc.) to the sub-pixels SP may be arranged.

The non-display area NDA included in the waist area WA may further include a connection area CLA in which the driving power lines arranged in the driving power line area PLA are extended and gate lines for transmitting gate signals output from the gate-in-panel circuit to the sub-pixels SP are arranged.

The non-display area NDA included in the waist area WA may further include a first free space FA1 between the base voltage line area VSSA and the crack stopper area CSA, and a second free space FA2 between the crack stopper area CSA and a trimming line. Here, the trimming line may correspond to a cutting line of the substrate 111.

The non-display area NDA included in the waist area WA may further include a connection area CLA in which the driving power lines arranged in the driving power line area PLA are extended and gate lines for transmitting gate signals output from the gate-in-panel circuit to the sub-pixels SP are arranged.

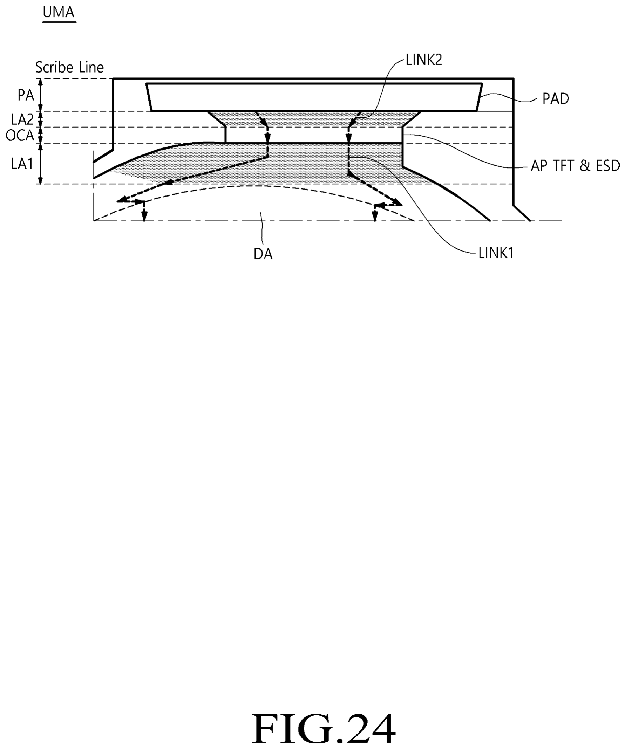

FIG. 24 illustrates a structure of a non-display area NDA in a first area A1 of a display panel 110 according to embodiments of the present disclosure.

FIG. 24 is a plan view of the uppermost area UMA in the first area A1 of FIG. 1. The uppermost area UMA may include a non-display area NDA outside the display area DA.

A non-display area NDA within the uppermost area UMA may include a first link area LA1 in which a plurality of first links LINK1 are arranged, an outer circuit area OCA in which inspection transistors AP TFT and electrostatic discharge pattern structures ESD are arranged, a second link area LA2 in which a plurality of second links LINK2 are arranged, and a pad area PA in which a plurality of pads PAD are arranged.

The plurality of first links LINK1 may be electrically connected to a plurality of data lines DL arranged in the display area DA. The plurality of second links LINK2 may be electrically connected to a plurality of first links LINK1.

Embodiments of the present disclosure described above are briefly described as follows.

A display device according to embodiments of the present disclosure may include a substrate including a display area and a non-display area outside the display area, the display area including an upper display area, a lower display area, and a middle display area between the upper display area and the lower display area, and the non-display area including a pad area closer to the upper display area than the middle display area, and a plurality of data lines arranged in the display area.

An n-th data line among the plurality of data lines may include an n-th upper data line arranged in the upper display area and extending in a first direction, an n-th lower data line arranged in the lower display area and extending in the first direction, and an n-th bypass link line passing through the middle display area and electrically connecting the n-th upper data line and the n-th lower data line. Here, n may be a natural number greater than or equal to 1.

A width of the middle display area may become narrower as one moves from a first boundary line (between the upper display area and the middle display area) approaching closer to a center of the middle display area. Likewise, the width of the middle display area may become narrower as one moves from a second boundary line (between the lower display area and the middle display area) approaching closer to the center of the middle display area.

The n-th bypass link line may be arranged to bypass a waist area dug inwardly within the middle display area.

The maximum width of the middle display area may be smaller than each of the maximum width of the upper display area and the maximum width of the lower display area.

The n-th bypass link line may include an n-th upper link line arranged in the display area, electrically connected to the n-th upper data line, and extending in a second direction different from the first direction, an n-th lower link line arranged in the display area, electrically connected to the n-th lower data line, and extending in the second direction, and an n-th middle link line arranged in the display area, electrically connecting the n-th upper link line and the n-th lower link line, and extending in the first direction.

The n-th upper link line may be arranged in the upper display area, the n-th lower link line may be arranged in the lower display area, and the n-th middle link line may pass through the middle display area in the first direction.

Each of two or more data lines including the n-th data line among the plurality of data lines may include an upper data line arranged in the upper display area and extending in the first direction, a lower data line arranged in the lower display area and extending in the first direction, and a bypass link line passing through the middle display area and electrically connecting the upper data line and the lower data line.

The bypass link line of each of the two or more data lines may include an upper link line arranged in the display area, electrically connected to the upper data line, and extending in a second direction different from the first direction, a lower link line arranged in the display area, electrically connected to the lower data line, and extending in the second direction, and a middle link line arranged in the display area, electrically connecting the upper link line and the lower link line, and extending in the first direction.

The display area may include an upper link area where an upper link line included in each of the bypass link lines of the two or more data lines is arranged, a lower link area where a lower link line included in each of the bypass link lines of the two or more data lines is arranged, and a middle link area where a middle link line included in each of the bypass link lines of the two or more data lines is arranged.

The upper link area may be included in the upper display area, the lower link area may be included in the lower display area, and the middle link area may be included in the upper display area, the middle display area, and the lower display area. For example, the upper link area may have a first triangle shape, the lower link area may have a second triangle shape, and the middle link area may have a quadrilateral shape. For example, the first triangle shape and the second triangle shape may be symmetrical to each other with respect to the middle display area. The middle link area may have a trapezoidal shape.

The display device according to embodiments of the present disclosure may further include power lines arranged in a mesh shape within the display area and to which a constant voltage level is applied. The power lines may be applied with a voltage that has a constant voltage level over time. For example, a voltage applied to the power lines may be a voltage applied to a common electrode.

The power lines may include an upper horizontal power line positioned in the upper display area, spaced apart from the n-th upper link line in the same row as the n-th upper link line, and arranged to extend in the second direction, an upper vertical power line positioned in the upper display area, spaced apart from the n-th middle link line in the same column as the n-th middle link line, and arranged to extend in the first direction, a lower horizontal power line positioned in the lower display area, spaced apart from the n-th lower link line in the same row as the n-th lower link line, and arranged to extend in the second direction, and a lower vertical power line positioned in the lower display area, spaced apart from the n-th middle link line in the same column as the n-th middle link line, and arranged to extend in the first direction.

The upper horizontal power line may intersect an (n-1)-th middle link line. The upper vertical power line may intersect an (n-1)-th upper link line. The lower horizontal power line may intersect the (n-1)-th middle link line. The lower vertical power line may intersect an (n-1)-th lower link line.

The (n-1)-th upper link line may be arranged on a side of the n-th upper link line and spaced apart from the n-th upper link line in the first direction. The (n-1)-th middle link line may be arranged on a side of the n-th middle link line and spaced apart from the n-th middle link line in the second direction. The (n-1)-th lower link line may be arranged on a side of the n-th lower link line and spaced apart from the n-th lower link line in the first direction.

Each of the upper vertical power line and the lower vertical power line may be arranged between two adjacent data lines among the plurality of data lines.

The upper vertical power line and the lower vertical power line may be arranged within a first metal layer together with the n-th upper data line, the n-th lower data line, and the n-th middle link line. The upper vertical power line, the lower vertical power line, the n-th upper data line, the n-th lower data line, and the n-th middle link line may be vertical lines.

The upper horizontal power line and the lower horizontal power line may be arranged within a second metal layer together with the n-th upper link line and the n-th lower link line. The second metal layer may be a metal layer different from the first metal layer. For example, the second metal layer may be a metal layer closer to the substrate than the first metal layer. In another example, the second metal layer may be a metal layer further away from the substrate than the first metal layer. The upper horizontal power line and the lower horizontal power line, the n-th upper link line, and the n-th lower link line may be horizontal lines.

The vertical lines including n-th upper data line, the n-th lower data line, and the n-th middle link line may be arranged within the first metal layer. The horizontal lines including the n-th upper link line and the n-th lower link line may be arranged within the second metal layer.

For example, one of the first metal layer and the second metal layer may be a source-drain metal layer on which a source electrode or a drain electrode of a transistor in the display area is disposed, and the other of the first metal layer and the second metal layer may be a gate metal layer on which a gate electrode of the transistor in the display area is disposed.

As another example, one of the first metal layer and the second metal layer may be a source-drain metal layer on which a source electrode or a drain electrode of a transistor in the display area is disposed, and the other of the first metal layer and the second metal layer may be a capacitor electrode metal layer on which one of two or more capacitor electrodes constituting a storage capacitor within the display area is disposed.

The substrate may include a waist area that is recessed (dug) inwardly.

The plurality of data lines may include a first data line group having a bypass link line disposed within the display area and bypassing the waist area, and a second data line group not having a bypass link line bypassing the waist area. The first data line group may include the n-th data line. A data line included in the second data line group may be arranged in a straight line shape. A data line included in the second data line group may pass through the upper display area, the middle display area, and the lower display area while extending in the first direction.

The substrate may include a first area including the upper display area, a second area including the lower display area, and a third area located between the first area and the second area, and including the middle display area.

The first area may include a pad area. The third area may include a waist area dug or curved inwardly. No data line supplied with a data signal is arranged in a non-display area included in the waist area.

The non-display area included in the waist area may include at least one of a driving power line area in which driving power lines are arranged, a gate-in-panel circuit area in which a gate-in-panel circuit is arranged, a base voltage line area in which a base voltage line is arranged, and a crack stopper area in which a crack stopper structure is arranged.

The display device may be a wearable device in the shape of glasses and the waist area may correspond to a position of a user's nose. For example, the waist area may correspond to the area that rests on the user's nose.

A display device according to embodiments of the present disclosure may include a substrate including a display area, a first signal line disposed on the substrate, extending in a first direction in the display area, and disposed within a first metal layer, and a second signal line disposed on the substrate, extending in a second direction different from the first direction in the display area, and disposed within a second metal layer different from the first metal layer.

The display device according to embodiments of the present disclosure may further include a third signal line disposed on the substrate, extending in the first direction in the display area, and disposed within the first metal layer, a fourth signal line disposed on the substrate, extending in the second direction in the display area, and disposed within the second metal layer, and a fifth signal line disposed on the substrate, extending in the first direction in the display area, and disposed within the first metal layer.

The first to fifth signal lines may be electrically connected. For example, the first to fifth signal lines may be data lines to which a data signal is applied.

The substrate may include a waist area recessed (dug) or curved inwardly. The waist area may be located on one side of the third signal line.

According to at least one of the embodiments of the present disclosure, it is possible to provide a display device having a data link structure capable of reducing a bezel by arranging data lines or link lines for connecting the data lines in a display area.

According to at least one of the the embodiments of the present disclosure, it is possible to provide a display device having a power line structure in which power lines are arranged in a mesh form within a display area, thereby reducing the resistance of the power lines, improving the power supply characteristics through the power lines, improving display driving performance, and enabling the low-power driving.

According to at least one of the the embodiments of the present disclosure, it is possible to provide a display device having a data link structure capable of reducing a bezel and a power line structure linked thereto, so that process optimization can be provided since the data link structure and the power line structure do not need to be formed separately.

According to at least one of the the embodiments of the present disclosure, it is possible to provide a display device of a heterogeneous display type having a data link structure capable of reducing a bezel.

According to at least one of the the embodiments of the present disclosure, it is possible to provide a display device as a wearable device having a data link structure capable of reducing a bezel. Here, the wearable device may include a virtual reality (VR) device, an augmented reality (AR) device, a mixed reality (MR) device, or an extended reality (XR) device.

## Claims

1. A display device (100) comprising:
a substrate (111) including a display area (DA) and a non-display area (NDA) outside the display area (DA), the display area (DA) including an upper display area (DA_TOP), a lower display area (DA_BOT), and a middle display area (DA_MID) between the upper display area (DA_TOP) and the lower display area (DA_BOT), and the non-display area (NDA) including a pad area (PA) closer to the upper display area (DA_TOP) than the middle display area (DA_MID); and
a plurality of data lines (DL) arranged in the display area, (DA)
wherein an n-th data line (DL(n)) among the plurality of data lines (DL) includes:
an n-th upper data line (DL(n)_TOP) arranged in the upper display area (DA_TOP) and extending in a first direction;
an n-th lower data line (DL(n)_BOT) arranged in the lower display area (DA_BOT) and extending in the first direction; and
an n-th bypass link line (DL(n)_BLL) passing through the middle display area (DA_MID) and electrically connecting the n-th upper data line (DL(n) _TOP) and the n-th lower data line (DL(n)_BOT),
wherein n is a natural number greater than or equal to 1.

2. The display device (100) of claim 1, wherein a first boundary line (BL1) delineates a boundary between the upper display area (DA_TOP) and the middle display area (DA_MID),
wherein a second boundary line (BL2) delineates a boundary between the lower display area (DA_BOT) and the middle display area (DA_MID),
wherein the middle display area (DA_MID) has a waist area (WA) in which: (i) a width of the middle display area (DA_MID) becomes narrower, from the first boundary line (BL1) towards a center of the middle display area (DA_MID), and (ii) the width of the middle display area (DA_MID) becomes narrower, from the second boundary line (BL2) towards the center of the middle display area (DA_MID), wherein the width is along the second direction, and
wherein the n-th bypass link line (DL(n)_BLL) is arranged to bypass the waist area (WA) of the middle display area (DA_MID).

3. The display device (100) of claim 1 or 2, wherein the n-th bypass link line (DL(n)_BLL) includes:
an n-th upper link line (HLIA_DATA(n)_TOP) arranged in the display area (DA), electrically connected to the n-th upper data line (DL(n) _TOP), and extending in a second direction different from the first direction;
an n-th lower link line (HLIA_ DATA(n)_BOT) arranged in the display area (DA), electrically connected to the n-th lower data line (DL(n)_BOT), and extending in the second direction; and
an n-th middle link line (VLIA_DATA(n)) arranged in the display area (DA), electrically connecting the n-th upper link line (HLIA_DATA(n)_TOP) and the n-th lower link line (HLIA_DATA(n)_BOT), and extending in the first direction.

4. The display device of claim 3, wherein the n-th upper link line (HLIA_DATA(n)_TOP) is arranged in the upper display area (DA_TOP), the n-th lower link line (HLIA_DATA(n)_BOT) is arranged in the lower display area (DA_BOT), and the n-th middle link line (VLIA_DATA(n)) passes through the middle display area (DA_MID) in the first direction.

5. The display device (100) of any of claims 1 to 4, wherein each of two or more data lines including the n-th data line (DL(n)) among the plurality of data lines (DL) includes:
an upper data line arranged in the upper display area (DA_TOP) and extending in the first direction;
a lower data line arranged in the lower display area (DA_BOT) and extending in the first direction; and
a bypass link line (DL_BLL) passing through the middle display area (DA_MID) and electrically connecting the upper data line and the lower data line,
wherein a bypass link line (DL_BLL) of each of the two or more data lines includes:
an upper link line arranged in the display area (DA), electrically connected to the upper data line, and extending in a second direction different from the first direction;
a lower link line arranged in the display area (DA), electrically connected to the lower data line, and extending in the second direction; and
a middle link line arranged in the display area (DA), electrically connecting the upper link line and the lower link line, and extending in the first direction,
wherein the display area (DA) includes:
an upper link area (HLIA_TOP_ZONE) where an upper link line included in each of the bypass link lines (DL_BLL) of the two or more data lines is arranged;
a lower link area (HLIA_BOT_ZONE) where a lower link line included in each of the bypass link lines (DL_BLL) of the two or more data lines is arranged; and
a middle link area (VLIA_ZONE) where a middle link line included in each of the bypass link lines (DL_BLL) of the two or more data lines is arranged,
wherein the upper link area (HLIA_TOP_ZONE) is included in the upper display area (DA_TOP),
wherein the lower link area (HLIA_BOT_ZONE) is included in the lower display area (DA_BOT), and
wherein the middle link area (VLIA_ZONE) is included in the upper display area (DA_TOP), the middle display area (DA_MID), and the lower display area (DA_BOT).

6. The display device (100) of claim 5, wherein the upper link area (HLIA_TOP_ZONE) has a first triangle shape,
wherein the lower link area (HLIA_BOT_ZONE) has a second triangle shape,
wherein the middle link area (VLIA_ZONE) has a quadrilateral shape,
wherein, preferably:
the first triangle shape and the second triangle shape are symmetrical to each other with respect to the middle display area (DA_MID), and
the middle link area (VLIA_ZONE) has a trapezoidal shape.

7. The display device (100) of claim 3 or any of claims 4 to 6 referring, directly or indirectly, back to claim 3, further comprising power lines (VSSL) arranged in a mesh shape within the display area (DA) and to which a constant voltage level is applied.

8. The display device (100) of claim 7, wherein the power lines (VSSL) include:
an upper horizontal power line (HLIA_VSS_TOP) positioned in the upper display area (DA_TOP), spaced apart from the n-th upper link line (HLIA_DATA(n)_TOP) in a same row as the n-th upper link line (HLIA_DATA(n)_TOP), and arranged to extend in the second direction;
an upper vertical power line (VLIA_VSS_TOP) positioned in the upper display area (DA_TOP), spaced apart from the n-th middle link line (VLIA_DATA(n)) in a same column as the n-th middle link line (VLIA_DATA(n)), and arranged to extend in the first direction;
a lower horizontal power line (HLIA_VSS_BOT) positioned in the lower display area (DA_BOT), spaced apart from the n-th lower link line (HLIA_DATA(n)_BOT) in the same row as the n-th lower link line (HLIA_DATA(n)_BOT), and arranged to extend in the second direction; and
a lower vertical power line (VLIA_VSS_BOT) positioned in the lower display area (DA_BOT), spaced apart from the n-th middle link line (VLIA_DATA(n)) in the same column as the n-th middle link line (VLIA_DATA(n)), and arranged to extend in the first direction.

9. The display device (100) of claim 8, wherein the upper horizontal power line (HLIA_VSS_TOP) intersects an (n-1)-th middle link line (VLIA_DATA(n-1)),
wherein the upper vertical power line (VLIA_VSS_TOP) intersects an (n-1)-th upper link line (HLIA_DATA(n-1)_TOP),
wherein the lower horizontal power line (HLIA_VSS_BOT) intersects the (n-1)-th middle link line (VLIA_DATA(n-1)),
wherein the lower vertical power line (VLIA_VSS_BOT) intersects an (n-1)-th lower link line (HLIA_DATA(n-1)_BOT),
wherein the (n-1)-th upper link line (HLIA_DATA(n-1)_TOP) is arranged on a side of the n-th upper link line (HLIA_DATA(n)_TOP) and spaced apart from the n-th upper link line (HLIA_DATA(n)_TOP) in the first direction,
wherein the (n-1)-th middle link line (VLIA_DATA(n-1)) is arranged on a side of the n-th middle link line (VLIA_DATA(n)) and spaced apart from the n-th middle link line (VLIA_DATA(n)) in the second direction, and
wherein the (n-1)-th lower link line (HLIA_DATA(n-1)_BOT) is arranged on a side of the n-th lower link line (HLIA_DATA(n)_BOT) and spaced apart from the n-th lower link line (HLIA_DATA(n)_BOT) in the first direction.

10. The display device (100) of claim 8 or 9, wherein each of the upper vertical power line (VLIA_VSS_TOP) and the lower vertical power line (VLIA_VSS_BOT) is arranged between two adjacent data lines among the plurality of data lines (DL).

11. The display device (100) of any of claims 8 to 10, wherein the upper vertical power line (VLIA_VSS_TOP) and the lower vertical power line (VLIA_VSS_BOT) are arranged within a first metal layer (ML1) together with the n-th upper data line (DL(n)_TOP), the n-th lower data line (DL(n)_BOT), and the n-th middle link line (VLIA_DATA(n)), and
wherein the upper horizontal power line (HLIA_VSS_TOP) and the lower horizontal power line (HLIA_VSS_BOT) are arranged within a second metal layer (ML2) different from the first metal layer (ML1) together with the n-th upper link line (HLIA_DATA(n)_TOP) and the n-th lower link line (HLIA_DATA(n)_BOT).

12. The display device (100) of claim 4 or any of claims 5 to 10 referring, directly or indirectly, back to claim 4, wherein the n-th upper data line (DL(n)_TOP), the n-th lower data line (DL(n)_BOT), and the n-th middle link line (VLIA_DATA(n)) are arranged within a first metal layer (ML1), and
wherein the n-th upper link line (HLIA_DATA(n)_TOP) and the n-th lower link line (HLIA_DATA(n)_BOT) are arranged within a second metal layer (ML2) different from the first metal layer (ML1).

13. The display device (100) of claim 12, wherein:
one of the first metal layer (ML1) and the second metal layer (ML2) is a source-drain metal layer (SDML) on which a source electrode or a drain electrode of a transistor in the display area (DA) is disposed, and the other of the first metal layer (ML1) and the second metal layer (ML2) is a gate metal layer (GML) on which a gate electrode of the transistor in the display area (DA) is disposed;
or wherein:
one of the first metal layer (ML1) and the second metal layer (ML2) is a source-drain metal layer (SDML) on which a source electrode or a drain electrode of a transistor in the display area (DA) is disposed, and the other of the first metal layer (ML1) and the second metal layer (ML2) is a capacitor electrode metal layer (TML) on which one of two or more capacitor electrodes constituting a storage capacitor within the display area (DA) is disposed.

14. The display device (100) of claim 1, wherein the substrate (111) includes a waist area (WA) that is recessed inwardly,
wherein the plurality of data lines (DL) include:
a first data line group (GR1) having a bypass link line (DL_BLL) disposed within the display area (DA) and bypassing the waist area (WA); and
a second data line group (GR2) not having a bypass link line (DL_BLL) bypassing the waist area (WA),
wherein the first data line group (GR1) includes the n-th data line (DL(n)), and
wherein a data line included in the second data line group (GR2) passes through the upper display area (DA_TOP), the middle display area (DA_MID), and the lower display area (DA_BOT) while extending in the first direction.

15. The display device (100) of claim 1, wherein the substrate (111) includes:
a first area (A1) including the upper display area (DA_TOP);
a second area (A2) including the lower display area (DA_BOT); and
a third area (A3) located between the first area (A1) and the second area (A2), and including the middle display area (DA_MID),
wherein the third area (A3) includes a waist area (WA) recessed inwardly,
wherein the n-th bypass link line (DL(n)_BLL) is arranged according to a shape of the waist area (WA), and
wherein a line supplied with a data signal is not arranged in a non-display area (NDA) included in the waist area (WA),
wherein, preferably, the display device (100) is a wearable device in the shape of glasses or a heterogeneous display device, and the waist area (WA) corresponds to a position of a user's nose.
